(19) **Europäisches Patentamt**
**European Patent Office**
**Office européen des brevets**

(11) **EP 4 641 237 A1**

(12) **EUROPEAN PATENT APPLICATION**
published in accordance with Art. 153(4) EPC

(43) Date of publication:
**29.10.2025 Bulletin 2025/44**

(21) Application number: **24874899.8**

(22) Date of filing: **25.09.2024**

(51) International Patent Classification (IPC):
$G01R\ 31/396^{(2019.01)}$   $G01R\ 31/367^{(2019.01)}$
$G01R\ 31/3842^{(2019.01)}$   $G01R\ 31/392^{(2019.01)}$
$G01R\ 31/36^{(2020.01)}$   $B60L\ 58/16^{(2019.01)}$
$H01M\ 10/052^{(2010.01)}$   $G01R\ 31/3828^{(2019.01)}$
$G01R\ 31/385^{(2019.01)}$   $H01M\ 10/48^{(2006.01)}$

(52) Cooperative Patent Classification (CPC):
**B60L 58/16; G01R 31/36; G01R 31/367;
G01R 31/3828; G01R 31/3842; G01R 31/385;
G01R 31/392; G01R 31/396; H01M 10/052;
H01M 10/48;** Y02E 60/10

(86) International application number:
**PCT/KR2024/014535**

(87) International publication number:
**WO 2025/075341 (10.04.2025 Gazette 2025/15)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.10.2023 KR 20230133644
09.11.2023 KR 20230154875
29.04.2024 KR 20240057162**

(71) Applicant: **LG Energy Solution, Ltd.
Seoul 07335 (KR)**

(72) Inventors:
• **KIM, Ji-Yeon
Daejeon 34122 (KR)**
• **KIM, Young-Deok
Daejeon 34122 (KR)**
• **PARK, Jun-Cheol
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY DIAGNOSIS METHOD AND BATTERY DIAGNOSIS APPARATUS**

(57) Disclosed is a battery diagnosis method and a battery diagnosis apparatus. The battery diagnosis method includes performing an intermittent application procedure of electric stimulation to a battery cell, obtaining state history data of the battery cell corresponding to a state change period until an electric state of the battery cell reaches a second state from a first state, generating a measurement full-cell profile representing a correspondence between a capacity and a voltage of the battery cell based on the state history data, and generating first diagnostic information including at least one diagnostic factor related to charge/discharge performance of the battery cell by analyzing the measurement full-cell profile.

EP 4 641 237 A1

FIG. 1

**Description**

TECHNICAL FIELD

The present disclosure relates to technology for non-destructively diagnosing a state of a battery.

The present application claims priority to Korean Patent Application No. 10-2023-0154875 filed on November 9, 2023, Korean Patent Application No. 10-2024-0057162 filed on April 29, 2024, and Korean Patent Application No. 10-2023-0133644 filed on October 6, 2023, in the Republic of Korea, the disclosures of which are incorporated herein by reference.

BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly recharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

Although much research is being done on these batteries in terms of increasing capacity and density, improvements in lifespan and safety are also important. In order to improve battery safety, the current state of the battery must be accurately diagnosed.

Accurately diagnosing the internal state of a battery cell is essential for safety and long lifespan of the battery cell. To diagnose the internal state of a battery cell without disassembly, relationship data (which can be referred to as a full-cell profile or the like) showing the correspondence between capacity and voltage is mainly used.

Conventionally, the full-cell profile is obtained by repeating the procedure of measuring voltage and capacity of a battery cell at short intervals while a constant electric stimulation (e.g., constant current charging or discharging) is applied to the battery cell. However, in order to minimize polarization (or overpotential) that causes a decrease in diagnostic accuracy, it is advantageous to lower the level of electric stimulation applied to the battery cell, which has the limitation that it takes excessive time to acquire the full-cell profile. Meanwhile, although high-level electric stimulation is advantageous in terms of shortening the time, it is not possible to guarantee the accuracy of the diagnostic result because the high-level electric stimulation is accompanied by a severe polarization phenomenon.

DISCLOSURE

Technical Problem

The present disclosure is designed to solve the problems of the related art, and therefore the present disclosure is directed to providing a battery diagnosis method and a battery diagnosis apparatus for obtaining relationship data that directly and indirectly represents the correspondence between capacity and voltage of a battery cell by executing an intermittent application procedure of electric stimulation in which application and removal of electric stimulation are alternately repeated. The polarization induced in the battery cell during the application period of electric stimulation is naturally reduced during the rest period of the electric stimulation. Therefore, even if the electric stimulation used in the intermittent application procedure has a high level, the actual charge/discharge characteristics of the battery cell may be sufficiently reflected in the obtained relationship data.

In addition, the present disclosure is directed to providing a battery diagnosis method and a battery diagnosis apparatus capable of generating diagnostic information related to charge/discharge performance of a battery cell based on the relationship data obtained by executing an intermittent application procedure.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided a battery diagnosis method comprising: obtaining state history data of a battery cell corresponding to a state change period until an electric state of the battery cell reaches a second state from a first state by an intermittent application procedure of electric stimulation to the battery cell; generating a measurement full-cell profile representing a correspondence between a capacity and a voltage of the battery cell based on the state history data; and generating first diagnostic information including at least one diagnostic factor related to charge/discharge performance of the battery cell by analyzing the measurement full-cell profile.

The electric stimulation may be a current stimulation that causes a transient voltage change exceeding a threshold value to the battery cell.

The electric stimulation may be a current stimulation that causes an overpotential exceeding a threshold value in the battery cell when the electric stimulation is continuously applied for a certain time.

The electric stimulation may be a charging current at a predetermined current rate.

The electric stimulation may be a discharging current at a predetermined current rate.

The state history data may include voltage values representing the voltage of the battery cell measured at least once during each of rest periods of the electric stimulation applied within the state change period.

The intermittent application procedure may include a procedure for removing the electric stimulation to the battery cell so that a rest period is provided to the battery cell whenever a current integration value of the battery cell changes by a threshold integration value during the application of the electric stimulation.

The intermittent application procedure may further include a procedure for resuming application of the electric stimulation whenever a duration of the rest period reaches a reference time.

The first diagnostic information may include at least one of a positive electrode participation start point, a positive electrode participation end point, a positive electrode scale factor, and a positive electrode loading amount, which represents charge/discharge performance of a positive electrode of the battery cell, as the diagnostic factor.

The battery diagnosis method may further comprise generating second diagnostic information including at least one degradation parameter regarding the positive electrode or available lithium of the battery cell by applying a mathematical operation to the first diagnostic information.

The first diagnostic information may include at least one of a negative electrode participation start point, a negative electrode participation end point, a negative electrode scale factor, and a negative electrode loading amount, which represents charge/discharge performance of a negative electrode of the battery cell, as the diagnostic factor.

The battery diagnosis method may further comprise generating second diagnostic information including at least one degradation parameter regarding the negative electrode of the battery cell by applying a mathematical operation to the first diagnostic information.

The battery diagnosis method may further comprise updating charge/discharge allowable condition information representing at least one of a voltage range, a SOC range, and a current range allowed for the battery cell based on at least one of the first diagnostic information and the second diagnostic information.

In still another aspect of the present disclosure, there is also provided a battery diagnosis apparatus comprising: a data obtaining unit configured to obtain state history data of a battery cell corresponding to a state change period until an electric state of the battery cell reaches a second state from a first state by an intermittent application procedure of electric stimulation to the battery cell; and a processor configured to generate a measurement full-cell profile representing a correspondence between a capacity and a voltage of the battery cell based on the state history data, wherein the processor is configured to generate first diagnostic information including at least one diagnostic factor related to charge/discharge performance of the battery cell by analyzing the measurement full-cell profile.

The intermittent application procedure may include a procedure for removing the electric stimulation to the battery cell so that a rest period is provided to the battery cell whenever a current integration value of the battery cell changes by a threshold integration value during the application of the electric stimulation.

The intermittent application procedure may further include a procedure for resuming application of the electric stimulation whenever a duration of the rest period reaches a reference time.

The first diagnostic information may include at least one of a positive electrode participation start point, a positive electrode participation end point, a positive electrode scale factor, and a positive electrode loading amount, which represents charge/discharge performance of a positive electrode of the battery cell, as the diagnostic factor.

The first diagnostic information may include at least one of a negative electrode participation start point, a negative electrode participation end point, a negative electrode scale factor, and a negative electrode loading amount, which represents charge/discharge performance of a negative electrode of the battery cell, as the diagnostic factor.

In another aspect of the present disclosure, there is also provided a charging station, comprising the battery diagnosis apparatus.

In still another aspect of the present disclosure, there is also provided a cloud server, comprising the battery diagnosis apparatus.

Advantageous Effects

According to at least one of the embodiments of the present disclosure, by applying a method of intermittently applying electric stimulation to a battery cell, relationship data representing the correspondence between capacity and voltage of the battery cell may be obtained, and diagnostic information representing charge/discharge performance of the battery cell may be generated based on the obtained relationship data.

Accordingly, even if a high level of electric stimulation is used to change the electric state of a battery cell, it is possible to prevent a decrease in diagnostic accuracy due to excessive polarization, and also it is possible to shorten the time required to obtain relationship data.

The effects of the present disclosure are not limited to the effects mentioned above, and these and other effects will be clearly understood by those skilled in the art from the appended claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a drawing referred to explain a battery diagnosis apparatus according to the present disclosure.
FIG. 2 is a graph referenced to describe an example of a reference positive electrode profile and a reference negative electrode profile, respectively.
FIGS. 3a and 3b are graphs referenced to exemplarily describe the process of obtaining a measurement full-cell profile of a battery cell.
FIGS. 4 to 6 are drawings referenced to describe an example of a procedure of generating a comparison full-cell profile used for comparison with the measurement full-cell profile according to an embodiment of the present disclosure.
FIGS. 7 to 9 are drawings referenced to describe another example of the procedure for generating a comparison full-cell profile used for comparison with the measurement full-cell profile according to an embodiment of the present disclosure.
FIG. 10 is a flowchart referenced to exemplarily describe a battery diagnosis method according to the first embodiment of the present disclosure.
FIG. 11 is a flowchart referenced to exemplarily describe a battery diagnosis method according to the second embodiment of the present disclosure.
FIG. 12 is a drawing referenced to describe a procedure of correcting voltage history data performed in Step S1122 of FIG. 11.

BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "... unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

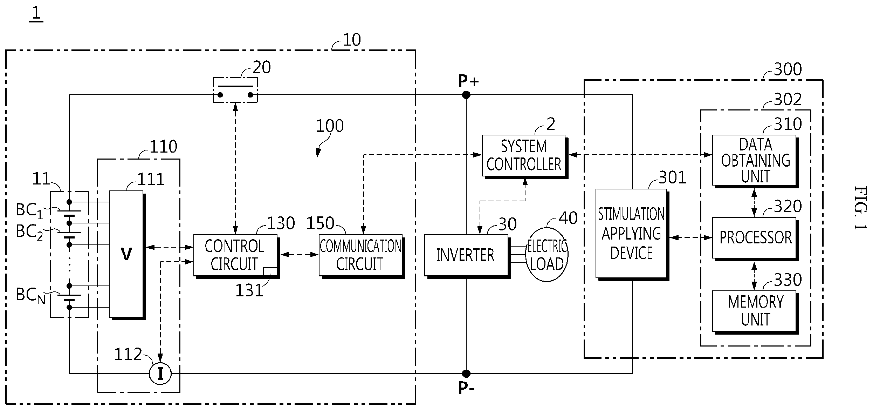

FIG. 1 is a drawing referred to explain a battery diagnosis apparatus according to the present disclosure.

Referring to FIG. 1, the battery system 1 includes a system controller 2, a battery pack 10, an inverter 30, and an electric load 40. Charging and discharging terminals P+ and P- of the battery pack 10 may be electrically connected to a charging station 300 through a charging cable or the like.

The system controller 2 (e.g., ECU: Electronic Control Unit) is configured to transmit a key-on signal to the battery management system 100 in response to that a start button (not shown) provided in the battery system 1 is switched to an ON position by a user. The system controller 2 is configured to transmit a key-off signal to the battery management system 100 in response to that the start button is switched to an OFF position by the user. The charging station 300 may communicate with the system controller 2 and supply a charging power selected from a constant power, a constant current, and a constant voltage through the charging and discharging terminals P+ and P- of the battery pack 10.

The battery pack 10 includes a battery 11, and may further include at least one of a relay 20 and a battery management system 100.

The battery 11 includes at least one battery cell BC. In FIG. 1, the battery 11 is exemplarily shown as including a plurality of battery cells ($BC_1$ to $BC_N$, N is a natural number of 2 or more) connected in series. The plurality of battery cells ($BC_1$ to $BC_N$) may be provided to have the same electrochemical specifications. Hereinafter, when explaining features common to the plurality of battery cells ($BC_1$ to $BC_N$), the reference sign 'BC' will be endowed to the battery cell. The charging station 300 may execute charging and discharging cycles necessary to diagnose the battery cell BC through collaboration with the inverter 30 having a discharging function.

The type of the battery cell BC is not specially limited as long as it is an electrochemical element capable of repeatedly charging and discharging. The battery cell BC is a target of diagnosis by the charging station.

The relay 20 is electrically connected in series to the battery 11 through a power path that connecting the battery 11 and the inverter 30. In FIG. 1, the relay 20 is illustrated as connected between the positive electrode terminal of the battery 11 and the charging and discharging terminal P+. The relay 20 is controlled to turn on and off in response to a switching signal from the battery management system 100. The relay 20 may be a mechanical contactor turned on and off by the magnetic force of a coil, or a semiconductor switch such as a MOSFET (Metal Oxide Semiconductor Field Effect transistor).

The inverter 30 is provided to convert DC current from the battery 11 included in the battery pack 10 into AC current in response to a command from the battery management system 100 or the system controller 2. The electric load 40 is driven using AC current power from the inverter 30. As the electric load 40, for example, a three-phase AC current motor may be used. The components in the battery system 1 that receive a discharging power from the battery 11, such as the inverter 30 and the electric load 40, may be collectively referred to as electric loads.

The battery management system 100 includes a sensing unit 110 and a control circuit 130. The battery management system 100 may further include a communication circuit 150.

The sensing unit 110 includes a voltage sensor 111. The sensing unit 110 may further include a current sensor 112.

The voltage sensor 111 is connected to the positive electrode terminal and the negative electrode terminal of the battery cell BC, and is configured to measure the voltage across both ends of the battery cell BC (also referred to as "full-cell voltage' or 'cell voltage') and generate a voltage signal representing the measurement value of the measured voltage. The voltage sensor 111 may be implemented as one or a combination of two or more of known voltage measurement elements such as a voltage measurement IC.

The current sensor 112 is connected in series to the battery 11 through a current path between the battery 11 and the inverter 30. The current sensor 112 is configured to measure the current (also referred to as a 'charging and discharging current') flowing through the battery 11 and generate a current signal representing the measurement value of the measured current. Since the plurality of battery cells ($BC_1$ to $BC_N$) are connected in series, the current flowing in the battery 11 is the same as the current flowing in the battery cell BC. The current sensor 112 may be implemented as one or a combination of two or more of known current measurement elements such as a shunt resistor, a Hall effect element, etc.

The communication circuit 150 is configured to support wired or wireless communication between the control circuit 130 and the system controller 2. The wired communication may be, for example, CAN (Controller Area Network) communication, and the wireless communication may be, for example, ZigBee or Bluetooth communication. The type of communication protocol is not particularly limited as long as it supports wired and wireless communication between the control circuit 130 and the system controller 2. The communication circuit 150 may include an output device (e.g., a display, a speaker) that provides information received from the control circuit 130 and/or the system controller 2 in a form recognizable to the user (driver).

The control circuit 130 is operably coupled to the relay 20, the voltage sensor 111, and the communication circuit 150. The operable coupling of any two components means that the two components are connected directly or indirectly to enable transmission and reception of signals in one direction or two directions.

The control circuit 130 may collect the voltage signal from the voltage sensor 111 and the current signal from the current sensor 112. In this specification, the measurement signal may a term referring only to a voltage signal, or a term collectively referring to a voltage signal and a current signal. That is, the control circuit 130 may convert each analog signal collected from the sensors 111 and 112 into a digital value using an ADC (Analog to Digital Converter) provided therein and record the digital value. Alternatively, each of the voltage sensor 111 and the current sensor 112 may include an ADC therein and transmit a digital value to the control circuit 130.

The control circuit 130 may be called a 'battery controller', and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The memory 131 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 131 may store data and programs required for calculation operations by the control circuit 130. The memory 131 may store data representing the result of a calculation operation performed by the control circuit 130.

The control circuit 130 may control charging/discharging of the battery cell BC according to the charge/discharge allowable condition information (including at least one of an allowable voltage range, an allowable SOC range, and an allowable current range), explained later. For example, if the full-cell voltage of the battery cell BC is out of the allowable voltage range or the SOC of the battery cell BC is out of the SOC range, the control circuit 130 may prohibit turning on the relay 20, and otherwise, the control circuit 130 may allow turning on the relay 20. In addition, the control circuit 130 may control the relay 20 and/or the inverter 30 so that the magnitude of the current flowing through the battery cell BC does not exceed the allowable current range.

When the relay 20 is turned on, the battery 11 goes into a charging mode or a discharging mode. If the relay 20 is turned off while the battery 11 is being used in the charging mode or the discharging mode, the battery 11 switches to a rest mode.

The control circuit 130 may turn on the relay 20 in response to a key-on signal. The control circuit 130 may turn off the relay 20 in response to a key-off signal. The key-on signal is a signal that requests switching from the rest mode to the charging or discharging mode. The key-off signal is a signal that requests switching from the charging or discharging mode to the resting mode. Alternatively, the system controller 2 may be responsible for turning on/off the relay 20 instead of the control circuit 130.

In this specification, history data of a certain parameter indicates the change history of the parameter over time. In addition, a profile (or curve), which represents the correspondence of any two parameters (e.g., 'voltage' and 'capacity', or 'voltage' and 'current') obtained at the same timing in the same period, may be a mapping of two history data of two parameters so that they may be expressed in the form of a two-dimensional graph, or may be a polynomial equation obtained by applying a predetermined curve fitting logic to the set of two mapped history data. Here, the degree of the highest term of the polynomial equation may be predetermined.

The battery diagnosis apparatus 302 includes a data obtaining unit 310, a processor 320, and a memory unit 330.

The charging station 300 may include a stimulation applying device 301 and a battery diagnosis apparatus 302 as in FIG. 1. Of course, the battery diagnosis apparatus 302 may also be configured to operate independently from the charging station 300. For example, the battery diagnosis apparatus 302 may be provided to be included in a cloud server (not shown). The cloud server may be placed remotely from the charging station 300. In this case, the data obtaining unit 310 of the battery diagnosis apparatus 302 may perform diagnostic procedures for a battery cell BC through remote communication with the stimulation applying device 301 and/or the battery system 1. Hereinafter, the battery cell BC to be diagnosed may be simply called a 'target cell'.

Alternatively, the battery diagnosis apparatus 302 may be included in the battery pack 10 as a replacement device for the battery management system 100, and the battery management system 100 may be omitted from the battery pack 10. In this case, the processor 320 may be responsible for all functions of the control circuit 130 of the battery management system 100, and the data obtaining unit 310 may be responsible for all functions of the communication circuit 150 of the battery management system 100. Also, the data obtaining unit 310 may be implemented to include the sensing unit 110.

The stimulation applying device 301 may include a charger that provides a charging power for normal charging of the battery pack 10. The stimulation applying device 301, alone or in collaboration with the inverter 30, may apply or remove at least one type of electric stimulation to the battery cell BC for diagnosis of the battery cell BC.

The data obtaining unit 310 is configured to support wired or wireless communication between the processor 320 and the system controller 2. The data obtaining unit 310 may transmit the result of diagnosis for the battery cell BC performed by the processor 320 to the battery system 1. The data obtaining unit 310 may be included as a sub-component of the processor 320.

In terms of hardware, the processor 320 may be implemented using at least one of ASICs (application specific integrated circuits), DSPs (digital signal processors), DSPDs (digital signal processing devices), PLDs (programmable logic devices), FPGAs (field programmable gate arrays), microprocessors, and electrical units for performing other functions.

The memory unit 330 may include, for example, at least one type of storage medium among flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory unit 330 may store data and programs required for diagnostic procedures performed by the processor 320. The memory unit 330 may store data representing the result of a calculation operation by the processor 320. The memory unit 330 may store data sets and software used to diagnose the degradation state of the battery cell BC.

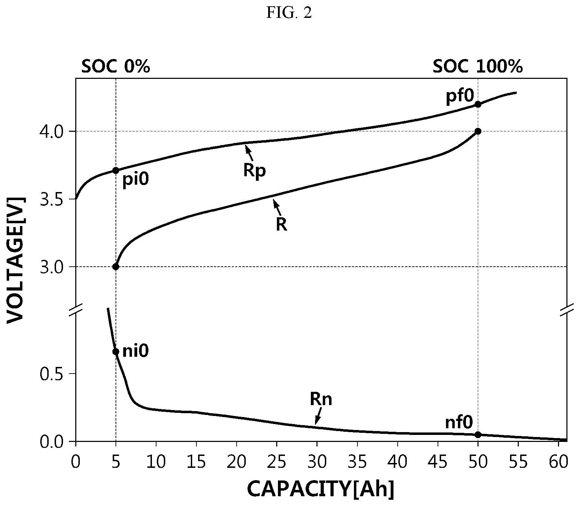

FIG. 2 is a graph referenced to describe an example of each of a reference positive electrode profile and a reference negative electrode profile. In the graph of FIG. 2, the horizontal axis (X-axis) represents capacity (Ah) and the vertical axis (Y-axis) represents voltage.

Referring to FIG. 2, the memory unit 330 may store a reference positive electrode profile Rp and a reference negative electrode profile Rn. The reference cell may be a coin-type cell including a positive electrode half-cell and a negative electrode half-cell, or may be a 3-electrode cell. Hereinafter, the positive electrode of the reference cell and the positive electrode half-cell will be described in equivalent terms, and the negative electrode of the reference cell and the negative electrode half-cell will be described in equivalent terms.

The reference positive electrode profile Rp may be a profile representing the correspondence between the positive electrode voltage and the capacity of the reference cell. The positive electrode voltage of the reference cell refers to a potential difference between the potential of a reference electrode (not shown) and the potential of the positive electrode of the reference cell. The positive electrode profile may also be referred to as a positive electrode half-cell profile.

The reference negative electrode profile Rn may be a profile representing the correspondence between the negative electrode voltage and the capacity of the reference cell. The negative electrode voltage of the reference cell refers to a potential difference between the potential of the reference electrode and the potential of the negative electrode of the reference cell. The negative electrode profile may also be referred to as a negative electrode half-cell profile.

The potential of the reference electrode may be, for example, a redox potential of lithium. The positive electrode voltage may be simply referred to as a positive electrode potential, and the negative electrode voltage may simply be referred to as a negative electrode potential.

Each of the positive electrode voltage and the negative electrode voltage may be an open circuit voltage (OCV) or a closed circuit voltage (CCV).

A first charge protocol or a first discharge protocol may be used to obtain the closed circuit voltage of each of the positive electrode and the negative electrode of the reference cell. The first charge protocol may be a constant current charging method using the first current rate. The first discharge protocol may be a constant current discharge method using the first current rate (e.g., 0.05 C). For example, while the reference cell is continuously charged by the first charge protocol or continuously discharged by the first discharge protocol, the closed circuit voltages of the positive electrode and the negative electrode of the reference cell, which are measured periodically or aperiodicly, may be recorded as the positive electrode voltage and the negative electrode voltage of the reference cell.

When compared with the closed circuit voltage, the second charge protocol or the second discharge protocol may be utilized to obtain the open circuit voltage of each of the positive electrode and the negative electrode of the reference cell. The second charge protocol may be an intermittent charge method in which constant current charging using the second current rate (e.g., 3.0 C) and a rest period are alternately performed. The second discharge protocol may be an intermittent charge method in which constant current discharge using the second current rate and a rest period are alternately performed.

For example, whenever the charging time by the constant current charging of the second charge protocol passes by a set time or the charging capacity of the reference cell increases by a set capacity, the charging of the reference cell may be stopped for a predetermined rest time and then the constant current charging may be resumed. The charging capacity may be calculated by periodically or aperiodically accumulating the sample values of the charging current.

As another example, whenever the discharging time by the constant current discharging of the second discharge protocol passes by a set time or the discharge capacity of the reference cell decreases by a set capacity, the discharging of the reference cell may be stopped for a predetermined rest time and then the constant current discharging may be resumed. The discharging capacity may be calculated by periodically or aperiodically accumulating the sample values of the discharging current (i.e., the measurement value of the cell current).

At this time, multiple rest periods may be provided while the second charge protocol or the second discharge protocol is in progress, and the open circuit voltages of the positive electrode and the negative electrode of the reference cell, respectively, measured at specific timings within each rest period, may be recorded as the positive electrode voltage and the negative electrode voltage of the reference cell.

In this specification, a low level electric stimulation may be referred to as a 'first electric stimulation', and a high level electric stimulation may be referred to as a 'second electric stimulation'.

When the battery cell is assumed to be in a new product state, the first electric stimulation may refer to a current stimulation that induces a transient voltage change (e.g., the difference between OCV and CCV) equal to or less than a threshold value to the battery cell, and the second electric stimulation may refer to a current stimulation that induces a transient voltage change greater than the threshold value to the battery cell. The transient voltage change is based on Ohm's law according to the internal resistance of the battery cell and the current flowing in the battery cell, and may represent the difference between the voltage (i.e., OCV: open circuit voltage) of the battery cell immediately before the application of the electric stimulation and the voltage (i.e., CCV: closed circuit voltage) of the battery cell immediately after the application of the electric stimulation. If the electric stimulation is a charge-inducing stimulation, the transient voltage change may be called a 'voltage rise'. Conversely, if the electric stimulation is a discharge-inducing stimulation, the transient voltage change may be called a 'voltage drop'.

Alternatively, when that the battery cell is assumed to be in a new product state, the first electric stimulation may refer to a current stimulation that induces an overpotential less than the threshold value to the battery cell when the current stimulation is continuously applied for a certain period of time, and the second electric stimulation may refer to a current stimulation that induces an overpotential greater than the threshold value to the battery cell when the current stimulation is continuously applied for a certain period of time. When an electric stimulation is continuously applied for a certain period of time, the overpotential may represent the difference between the change amount of the OCV and the change amount of the CCV during the same period of time.

For example, the first electric stimulation may be a charging current at a predetermined current rate (e.g., the first current rate), and the second electric stimulation may be a charging current of a current rate (e.g., the second current rate) corresponding to a higher level than the first electric stimulation.

As another example, the first electric stimulation may be a discharging current at a predetermined current rate (e.g., the first current rate), and the second electric stimulation may be a discharging current of a current rate (e.g., the second current rate) corresponding to a higher level than the first electric stimulation.

Implementing the first charge protocol or the first discharge protocol may mean continuous application of the first electric stimulation to the battery cell. Implementing the second charge protocol or the second discharge protocol may mean intermittent application of the second electric stimulation to the battery cell.

For convenience of explanation, it is assumed that the horizontal axis represents the charging capacity in FIGS. 2 to 9.

At least one of the reference positive electrode profile Rp and the reference negative electrode profile Rn may be aligned along the horizontal axis so that the synthesis result of a part of the common capacity range (5 to 50 Ah in FIG. 2) of the two profiles (Rp, Rn) matches the reference full-cell profile R. FIG. 2 shows an example in which the reference negative electrode profile Rn is aligned to be shifted to the right based on the start point (point corresponding to capacity 0) of the reference positive electrode profile Rp.

It may be found from FIG. 2 that both ends of the reference positive electrode profile Rp and the reference negative electrode profile Rn are offset from each other. In other words, the capacity range of the reference positive electrode profile Rp and the capacity range of the reference negative electrode profile Rn do not match and only partially overlap. Therefore, the reference full-cell profile R indicates the full-cell voltage of a reference cell in a part of the capacity range common to the reference positive electrode profile Rp and the reference negative electrode profile Rn. In other words, the reference full-cell profile R is an example of the full-cell voltage profile obtained by directly subtracting a part of the reference negative electrode profile Rn from a part of the reference positive electrode profile Rp.

The reference full-cell profile R may represent the correspondence between the capacity and the full-cell voltage of a new battery cell that is verified as a good product. In other words, the reference cell has the same level of positive electrode performance and negative electrode performance as the new battery cell that is verified as a good product. The positive electrode performance and the negative electrode performance of any battery cell may be collectively referred to as the 'charge/discharge performance.'

The new battery cell refers to a battery cell in a new state. The new state may be the same concept as BOL (Beginning Of Life). For example, it may be called BOL before the time when the cumulative charge/discharge capacity from the time of manufacturing completion reaches the set capacity, and it may be called MOL (Middle Of Life) from the time when the cumulative charge/discharge capacity reaches the set capacity.

The reference full-cell profile R may represent the correspondence between the voltage and capacity of the reference cell over at least the voltage range of interest (e.g., 3.0 to 4.0V). The lower and upper limits of the voltage range of interest may be the first set voltage (3.0V in FIG. 2) and the second set voltage (4.0V in FIG. 2).

If the full-cell voltage of any battery cell, including the reference cell, is equal to the first set voltage, SOC may be set to 0%. When the full-cell voltage of any battery cell, including the reference cell, is equal to the second set voltage, SOC may be set to 100%. According to FIG. 2, the reference cell may reach a full charge state (SOC 100%) from a full discharge state (SOC 0%) by a charging capacity of 45 Ah.

In this specification, the positive electrode participation start point on the positive electrode profile of any battery cell represents the positive electrode voltage and the positive electrode capacity (or positive electrode SOC) when the full-cell voltage of the corresponding battery cell matches the first set voltage. Also, the negative electrode participation start point on the negative electrode profile of the corresponding battery cell indicates the negative electrode voltage and the negative electrode capacity (or negative electrode SOC) when the full-cell voltage of the corresponding battery cell matches the first set voltage. Therefore, the voltage difference between the positive electrode participation start point and the negative electrode participation start point may be equal to the first set voltage.

In addition, the positive electrode participation end point on the positive electrode profile of any battery cell indicates the positive electrode voltage and the positive electrode capacity (or positive electrode SOC) when the full-cell voltage of the corresponding battery cell matches the second set voltage. Also, the negative electrode participation end point on the negative electrode profile of the corresponding battery cell indicates the negative electrode voltage and the negative electrode capacity (or negative electrode SOC) when the full-cell voltage of the corresponding battery cell matches the second set voltage. Therefore, the voltage difference between the positive electrode participation end point and the negative electrode participation end point may be equal to the second set voltage.

In this specification, the positive electrode capacity (capacity value) at a specific point on the positive electrode profile of any battery cell may mean the capacity difference between any one of both end points of the positive electrode profile and the specific point. The positive electrode SOC at a specific point on the positive electrode profile of any battery cell may mean the ratio of the capacity difference between any one of both end points (e.g., low capacity point) of the positive electrode profile and the specific point to the capacity difference between two end points of the positive electrode profile. The capacity difference between both end points of the positive electrode profile may be referred to as a total positive electrode capacity.

Likewise, the negative electrode capacity (capacity value) at a specific point on the negative electrode profile of any battery cell may mean the capacity difference between any one of both end points of the negative electrode profile (or positive electrode profile) and the specific point. The negative electrode SOC at a specific point on the negative electrode profile of any battery cell may mean the ratio of the capacity difference between any one of both end points (e.g., low capacity point) of the negative electrode profile (or positive electrode profile) and the specific point to the capacity difference between both end points of the negative electrode profile. The capacity difference between both end points of the negative electrode profile may be referred to as a total negative electrode capacity.

In the memory unit 330, the information indicating the voltage at each of the reference positive electrode participation start point (pi0), the reference positive electrode participation end point (pf0), the reference negative electrode participation start point (ni0), and the reference negative electrode participation end point (nf0) may be recorded in advance. The reference positive electrode participation start point (pi0) and the reference positive electrode participation end point (pf0) are the positive electrode participation start point and the positive electrode participation end point on the reference positive electrode profile Rp, respectively. The reference negative electrode participation start point (ni0) and the reference negative electrode participation end point (nf0) are the negative electrode participation start point and the negative electrode participation end point on the reference negative electrode profile Rn, respectively.

The voltage difference between the reference positive electrode participation start point (pi0) and the reference negative electrode participation start point (ni0) may be equal to the first set voltage (e.g., 3.0V). The voltage difference between the reference positive electrode participation end point (pf0) and the reference negative electrode participation end point (nf0) may be equal to the second set voltage (e.g., 4.0V).

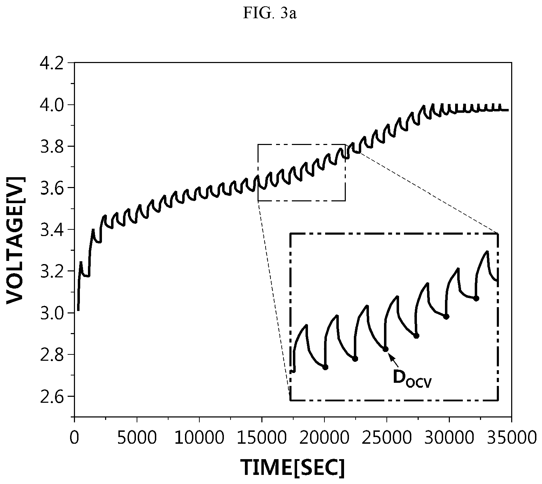

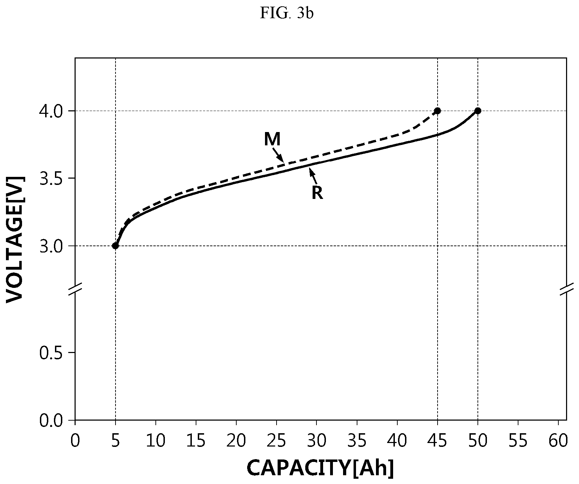

FIGS. 3a and 3b are graphs referenced to exemplarily describe the process of obtaining a measurement full-cell profile of a target cell.

The graph depicted in FIG. 3a shows an example of the change in full-cell voltage of the target cell over time due to intermittent application of the electric stimulation (e.g., the second electric stimulation described above). The target cell is a battery cell that is subject to diagnosis by the battery diagnosis apparatus. The target cell may be a new battery cell that requires verification as to whether it is a good product, or a battery cell that is no longer a new product due to degradation after being verified as a good product. Hereinafter, the target cell is also designated by a reference sign BC.

The processor 320 may control the stimulation applying device 301 to intermittently apply the electric stimulation to the target cell BC.

The procedure for controlling the stimulation applying device 301 to diagnose the target cell BC may be carried out during the state change period until the electric state (e.g., full-cell voltage corresponding to OCV) of the target cell BC changes from the first state (e.g., first set voltage) to the second state (e.g., second set voltage).

Referring to the graph in FIG. 3a, the full-cell voltage of the target cell BC has a rising trend while repeating a sawtooth-shaped form. Each sawtooth-shaped voltage rise segment is caused by the application of the electric stimulation, and the voltage drop segment is caused by the interruption of the electric stimulation. That is, the voltage drop segment represents the change in full-cell voltage of the target cell BC over each rest period.

During the state change period, the processor 320 may repeatedly record current measurement values of the target cell BC to generate current history data.

The processor 320 may control the stimulation applying device 301 to initiate a rest period of the electric stimulation whenever a predetermined rest condition is satisfied within the state change period. In other words, the procedure of applying the electric stimulation may be temporarily stopped when the rest condition is satisfied. For example, at least one of (i) the current integration value changes by a threshold integration value, (ii) the SOC changes by a threshold SOC, and (iii) the time for which the application of the electric stimulation is maintained reaches a threshold time may be preset as a rest condition. For example, if the total current integration value during the state change period is 40 Ah and the threshold integration value is 2 Ah, a total of 20 rest periods may be granted in the state change period.

The processor 320 may determine at least one of the threshold integration value, the threshold SOC, and the threshold time based on the full charge capacity of the target cell BC, the SOH, or the previous diagnosis result (e.g., the capacity value of the negative electrode participation end point, the negative electrode loss rate). At least one of the threshold integration value, the threshold SOC, and the threshold time may have a predetermined positive (or negative) correspondence with the full charge capacity, the SOH, or the previous diagnosis result, and the relationship data (data table for controlling the rest period) in which this correspondence is defined may be stored in advance in the memory unit 330. Due to the predetermined positive (or negative) correspondence, as the full charge capacity, the SOH, or the previous diagnosis result decreases, at least one of the threshold integration value, the threshold SOC, and the threshold time also decreases. As a result, as the target cell BC degrades over time, rest periods are given at short time intervals within the state change period, so it is possible to prevent the number of data points included in the voltage history data, which indicates the change history of the full-cell voltage over time during the rest periods of the state change period, from being reduced.

The processor 320 may obtain at least one of the threshold integration value, the threshold SOC, and the threshold time mapped to the full charge capacity, the SOH, or the previous diagnosis result from the data table for rest period control. The processor 320 may control the intermittent application procedure of the electric stimulation over the state change period using at least one of the threshold integration value, the threshold SOC, and the threshold time obtained from the data table for rest period control.

The processor 320 may control the stimulation applying device 301 to resume application of the electric stimulation when the reference time passes from the start time point of the rest period of the electric stimulation. The reference time may be predetermined so that the polarization caused by the electric stimulation may be sufficiently resolved. For example, the reference time, which is the length of time of the rest period, may be the time required for the polarization at the start time point of the rest period to become 10% or less.

In each rest period of the electric stimulation, the full-cell voltage of the target cell BC is measured at least once. As an example, the processor 320 may record the measurement value of the full-cell voltage at the end time point of each rest period of the electric stimulation as the OCV of the target cell BC. As another example, the full-cell voltage may be measured at least three times in each rest period of the electric stimulation, and the processor 320 may estimate the OCV of the target cell BC for each rest period based on the three full-cell voltage measurement values for each rest period.

Accordingly, the voltage history data may be generated by recording the OCV multiple times with time differences during the state change period. Each OCV point ($D_{OCV}$) marked in FIG. 3a is an example of a data point representing the voltage history data.

The inventors of the present disclosure have recognized through multiple experiments that the voltage history data generated in the above intermittent application manner using the second electric stimulation has high consistency with the voltage history data generated when actually continuously applying the first electric stimulation to the target cell BC.

From now on, the advantages of a diagnostic method based on intermittent application of the second electric stimulation instead of continuous application of the first electric stimulation will be described.

It is assumes that the conditions related to the diagnosis of the target cell BC are as follows.

(i) First electric stimulation = charging at 0.05 C
(ii) Second electric stimulation = charging at 3.0 C
(iii) Length of the rest period of the second electric stimulation = 12 minutes
(iv) Total capacity change during the state change period = 80% of the full charge capacity (FCC) of the target cell BC
(v) Threshold integration value = 3% of the full charge capacity of the target cell BC

Then, the time taken for the target cell BC to change from the first state to the second state by continuously applying the first electric stimulation is 1/0.05*80% = 16 hours.

In comparison, the time taken for the charging capacity of the target cell BC to increase by the threshold integration value by the second electric stimulation is 0.03/3*80% = 0.008 hours. Also, since a rest period is granted whenever the charging capacity increases by 3%, a total of 26 rest periods are granted during the state change period. Therefore, the time taken for the target cell BC to change from the first state to the second state by intermittent application of the second electric stimulation is (0.008 hours+0.2 hours)*26 = 5.4 hours.

In other words, compared to the method of continuously applying the first electric stimulation, the method of intermittently applying the second electric stimulation is advantageous in shortening the time for obtaining the full-cell profile.

In the graph of FIG. 3b, the horizontal axis (X-axis) represents capacity (Ah) and the vertical axis (Y-axis) represents voltage.

Referring to FIG. 3b, the processor 320 may generate a measurement full-cell profile M representing the correspondence between capacity and voltage (also referred to as 'full-cell voltage') of the target cell BC. The measurement full-cell profile may also be referred to as a Q-V profile or a Q-OCV profile.

Here, the full-cell voltage is the voltage across both ends of the target cell BC, and is distinguished from the positive electrode voltage and the negative electrode voltage described above. In other words, the full-cell voltage of the target cell BC may be regarded as the difference between the positive electrode voltage and the negative electrode voltage of the target cell BC.

To generate the measurement full-cell profile M, the state history data mapped to the state change period may be utilized. The state history data includes the voltage history data described above, and may further include the current history data or the capacity history data.

In detail, each data point of the current history data and the voltage history data is indexed in time order. Accordingly, the processor 320 may generate capacity history data by sequentially integrating data points of the current history data. In addition, the processor 320 may generate a measurement full-cell profile M by applying a curve fitting algorithm to a set of multiple Q-OCV pairs obtained by mapping between the capacity history data and the voltage history data. The reference full-cell profile R, the reference positive electrode profile Rp, the reference negative electrode profile Rn, and the measurement full-cell profile M may be a polynomial equation where the order of the highest term is predetermined.

Like the reference full-cell profile R, the measurement full-cell profile M may represent the correspondence between the capacity of the target cell BC over at least the voltage range of interest (e.g., 3.0 to 4.0V) and the OCV.

Since there is inevitably some difference in the charge/discharge performance between the reference cell and the target cell BC, there is also some difference between the measurement full-cell profile M and the reference full-cell profile R, as shown in FIG. 3b.

For example, at the same capacity value, the voltage of the measurement full-cell profile M is higher than the voltage of the reference full-cell profile R, which is caused by a manufacturing defect of the target cell BC, loss of the positive electrode capacity, loss of the negative electrode capacity, and/or loss of the available lithium. It is obvious that as the target cell BC degrades through repeated charge/discharge, the difference between the measurement full-cell profile M and the reference full-cell profile R will gradually increase. According to FIG. 3b, unlike the reference cell described with reference to FIG. 2, a charge capacity of 40 Ah is required for the full-cell voltage of the target cell BC to reach the second set voltage from the first set voltage, which is less than the charge capacity of 50 Ah of the reference cell by 5 Ah under the same conditions.

Meanwhile, in the graphs of FIGS. 2 and 3b, Ah is used as the unit on the horizontal axis, but this unit may be expressed in other forms. For example, the unit on the horizontal axis may be percentage %, which represents SOC (State Of Charge), instead of Ah.

When the measurement full-cell profile M is generated, the processor 320 may be configured to compare the measurement full-cell profile M with at least one comparison full-cell profile. Here, the comparison full-cell profile may be a result of generating an adjusted positive electrode profile and an adjusted negative electrode profile by adjusting each of the reference positive electrode profile Rp and the reference negative electrode profile Rn stored in the memory unit 330, and then synthesizing (combining) the adjusted positive electrode profile and the adjusted negative electrode profile.

In other words, when the reference full-cell profile R is the result of subtracting a part of the reference negative electrode profile Rn from a part of the reference positive electrode profile Rp, the comparison full-cell profile may be regarded as the result of subtracting a part of the adjusted negative electrode profile from a part of the adjusted positive electrode profile.

The processor 320 may generate at least one comparison full-cell profile by directly adjusting the reference positive electrode profile Rp and the reference negative electrode profile Rn. Alternatively, the at least one comparison full-cell profile may be secured in advance based on the reference positive electrode profile Rp and the reference negative electrode profile Rn and stored in the memory unit 330. In this case, the processor 320 may also obtain the comparison full-cell profile by accessing the memory unit 330 and reading the comparison full-cell profile.

The processor 320 may generate a plurality of comparison full-cell profiles from the reference positive electrode profile Rp and the reference negative electrode profile Rp by repeating an adjustment procedure of adjusting each of the reference positive electrode profile Rp and the reference negative electrode profile Rp to several levels and then synthesizing them. The comparison full-cell profile may also be referred to as an 'adjusted reference full-cell profile'.

The processor 320 may specify any one comparison full-cell profile among the plurality of comparison full-cell profiles, which has a minimum error with respect to the measurement full-cell profile M. Then, the processor 320 may determine that the adjusted positive electrode profile and the adjusted negative electrode profile mapped to the specified comparison full-cell profile are the positive electrode profile and the negative electrode profile of the target cell BC.

In relation to this, various methods known at the time of filing of this application may be employed to determine the error between two profiles, each of which may be expressed in a two-dimensional coordinate system. For example, the integral or the RMSE (Root Mean Square Error) of the absolute value of the area between the two profiles may be used as the error between the two profiles.

According to this configuration of the present disclosure, various state information about the target cell BC may be obtained based on the finally determined adjusted positive electrode profile and adjusted negative electrode profile. The finally determined adjusted positive electrode profile and adjusted negative electrode profile may be mapped to the comparison full-cell profile mapped with the minimum error. In particular, the comparison full-cell profile obtained by the finally determined adjusted positive electrode profile and adjusted negative electrode profile may be almost identical to the measurement full-cell profile M in shape, etc.

Therefore, according to the present disclosure, the positive electrode profile and the negative electrode profile for the target cell BC may be obtained even without disassembling the target cell BC or manufacturing it in the form of a 3-electrode battery.

If the target cell BC is the new battery cell, the adjusted positive electrode profile and the adjusted negative electrode profile may be analyzed and utilized more easily to diagnose whether a defect occurs in the target cell BC and, if so, what type of defect it is.

If a battery cell is used after the target cell BC is verified to be a good product, it is possible to determine how much the target cell BC is degraded for each degradation item through the adjusted positive electrode profile and the adjusted negative electrode profile.

Furthermore, according to an embodiment of the present disclosure, the positive electrode profile and the negative electrode profile of the target cell BC may be obtained in a simple manner. The present disclosure may be implemented even if only one reference positive electrode profile Rp and one reference negative electrode profile Rn are stored in the memory unit 330. That is, there is no need to store a plurality of reference positive electrode profiles Rp and/or a plurality of reference negative electrode profiles Rn in the memory unit 330. Accordingly, there is no need for the storage capacity of the memory unit 330 to be high, and there is no need to conduct a large number of preliminary tests required to secure a plurality of reference positive electrode profiles Rp and/or a plurality of reference negative electrode profiles Rn.

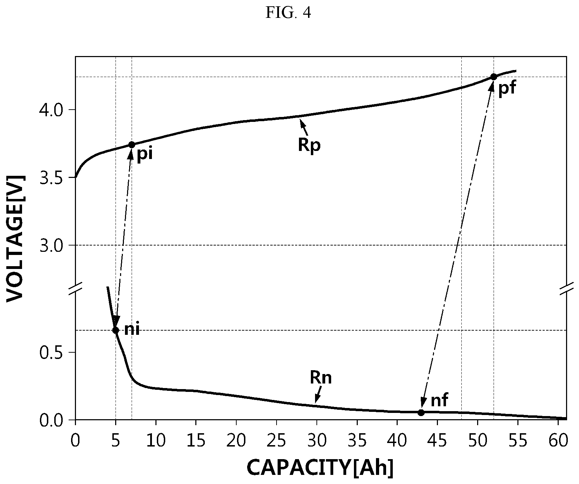

Hereinafter, referring to FIGS. 4 to 9, the process of analyzing the measurement full-cell profile M for estimating the negative electrode loading amount, which is one of the parameters involved in the current charge/discharge performance of the target cell BC, will be described. The negative electrode loading amount of any battery cell is a term indicating the amount of negative electrode active material per unit area of the negative electrode of the battery cell, and its unit may be mAh/cm$^2$ or mg/cm$^2$.

FIGS. 4 to 6 are diagrams referenced to describe an example of a procedure of generating a comparison full-cell profile used for comparison with the measurement full-cell profile according to an embodiment of the present disclosure.

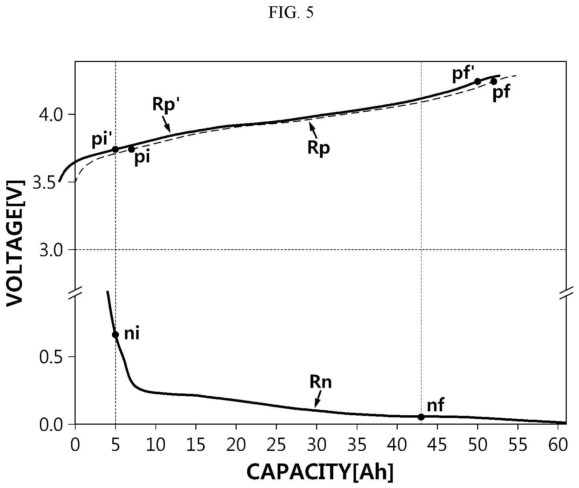

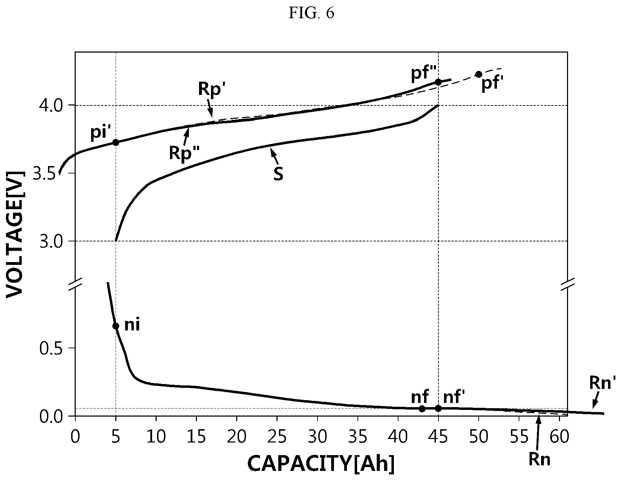

The procedure for generating a comparison full-cell profile, which will be explained with reference to FIGS. 4 to 6, proceeds in the order of a first routine for setting four points (positive electrode participation start point, positive electrode participation end point, negative electrode participation start point, negative electrode participation end point) to correspond to the voltage range of interest (see FIG. 4), a second routine for performing the profile shift (see FIG. 5), and a third routine for performing the capacity scaling (see FIG. 6). That is, the procedure for generating a comparison full-cell profile according to an embodiment of the present disclosure includes the first to third routines.

First, referring to FIG. 4, the reference positive electrode profile Rp and the reference negative electrode profile Rn are the same as those shown in FIG. 2.

The processor 320 determines the positive electrode participation start point (pi), the positive electrode participation end point (pf), the negative electrode participation start point (ni) and the negative electrode participation end point (nf) on the reference positive electrode profile Rp and the reference negative electrode profile Rn.

Either the positive electrode participation start point (pi) or the negative electrode participation start point (ni) depends on the other.

As an example, the processor 320 may divide the positive electrode voltage range from the start point to the end point (or, second set voltage) of the reference positive electrode profile Rp into a plurality of small voltage sections, and then determine a boundary point of two adjacent small voltage sections among the plurality of small voltage sections as a positive electrode participation start point (pi). Each small voltage section may have a predetermined size (e.g., 0.01V). Next, the processor 320 may determine a point on the reference negative electrode profile Rn that is smaller than the positive electrode participation start point (pi) by the first set voltage (e.g., 3V) as a negative electrode participation start point (ni).

As another example, the processor 320 may divide the negative electrode voltage range from the start point to the end point of the reference negative electrode profile Rn into a plurality of small voltage sections of a predetermined size, and then determine a boundary point of two adjacent small voltage sections among the plurality of small voltage sections as a negative electrode participation start point (ni). Next, the processor 320 may search for a point greater than the negative electrode participation start point (ni) by the first set voltage from the reference positive electrode profile Rp and determine the searched point as a positive electrode participation start point (pi).

Either the positive electrode participation end point (pf) or the negative electrode participation end point (nf) depends on the other.

As an example, the processor 320 may divide the voltage range from the second set voltage to the end point of the reference positive electrode profile Rp into a plurality of small voltage sections of a predetermined size, and then determine a boundary point two adjacent small voltage section among the plurality of small voltage sections as a positive electrode participation end point (pf). Next, the processor 320 may determine a point on the reference negative electrode profile Rn that is smaller than the positive electrode participation end point (pf) by the second set voltage (e.g., 4V) as a negative electrode participation end point (nf).

As another example, the processor 320 may divide the negative electrode voltage range from the start point to the end point of the reference negative electrode profile Rn into plurality of small voltage sections of a predetermined size, and then determine a boundary point between two adjacent small voltage sections among the plurality of small voltage sections as a negative electrode participation end point (nf). Next, the processor 320 may search for a point that is greater than the negative electrode participation end point (nf) by the second set voltage from the reference positive electrode profile Rp and determine the searched point as a positive electrode participation end point (pf).

If the positive electrode participation start point (pi), the positive electrode participation end point (pf), the negative electrode participation start point (ni), and the negative electrode participation end point (nf) are completely determined, the processor 320 shifts at least one of the reference positive electrode profile Rp and the reference negative electrode profile Rn to the left or right along the horizontal axis.

Referring to FIG. 5, the processor 320 may shift the reference positive electrode profile Rp to the left (toward low capacity) or shift the reference negative electrode profile Rn to the right (toward high capacity), or shift both of them, so that the capacity values of the positive electrode participation start point (pi) and the negative electrode participation start point (ni) match.

Alternatively, the processor 320 shifts the reference positive electrode profile Rp to the left or shift the reference negative electrode profile Rn to the right, or shift both of them, so that the capacity values of the positive electrode participation end point (pf) and the negative electrode participation end point (nf) match.

FIG. 5 illustrates a situation where only the reference positive electrode profile Rp is shifted to the left to generate an adjusted reference positive electrode profile (Rp'), and as a result, the capacity value of the positive electrode participation start point (pi') matches the capacity value of the negative electrode participation start point (ni). The adjusted reference positive electrode profile (Rp') is the result of applying an adjustment procedure that shifts to the left by the voltage difference between the positive electrode participation start point (pi) and the negative electrode participation start point (ni) to the reference positive electrode profile Rp. Therefore, the two points (pi, pi') are different only in capacity value and have the same voltage. The two points (pf, pf') are also different only in the capacity value and have the same voltage.

If the adjustment result profiles (Rp', Rn) in which at least one of the reference positive electrode profile Rp and the reference negative electrode profile Rn is shifted are secured, the processor 320 scales the capacity range of at least one of the adjustment result profiles (Rp', Rn).

According to the example shown in FIG. 5, the processor 320 performs an additional adjustment procedure to shrink or expand at least one of the adjusted reference positive electrode profile (Rp') and the reference negative electrode profile Rn along the horizontal axis.

Referring to FIG. 6, the processor 320 may generate an adjusted reference positive electrode profile (Rp") by shrinking or expanding the adjusted reference positive electrode profile (Rp') so that the size of the capacity range between two points (pi', pf') of the adjusted reference positive electrode profile (Rp') matches the size of the capacity range of the measurement full-cell profile M. At this time, any one point (pi') of the two points (pi', pf') may be fixed. Accordingly, the capacity difference between the two points (pi', pf") of the adjusted reference positive electrode profile (Rp") may match the capacity range of the measurement full-cell profile M.

In addition, the processor 320 may generate an adjusted reference negative electrode profile (Rn') by shrinking or expanding the reference negative electrode profile Rn so that the size of the capacity range between two points (ni, nf) of the reference positive electrode profile Rn matches the size of the capacity range of the measurement full-cell profile M. At this time, any one point (ni) of the two points (ni, nf) may be fixed. Accordingly, the capacity difference between the two points (ni, nf') of the adjusted reference negative electrode profile (Rn') may match the capacity range of the measurement full-cell profile M.

In FIG. 6, the adjusted reference positive electrode profile (Rp") is the result of shrinking the adjusted reference positive electrode profile (Rp') shown in FIG. 5, and the adjusted reference negative electrode profile (Rn') is the result of expanding the reference negative electrode profile Rn shown in FIG. 5.

The positive electrode participation end point (pf") on the adjusted reference positive electrode profile (Rp") corresponds to the positive electrode participation end point (pf) on the adjusted reference positive electrode profile (Rp'). The negative electrode participation end point (nf') on the adjusted reference negative electrode profile (Rn') corresponds to the negative electrode participation end point (nf) on the reference negative electrode profile (Rn).

The capacity difference between the positive electrode participation start point (pi') and the positive electrode participation end point (pf") of the adjusted reference positive electrode profile (Rp") corresponds to the size of the capacity range of the measured full-cell profile M. Likewise, the capacity difference between the negative electrode participation start point (ni) and the negative electrode participation end point (nf') of the adjusted reference negative electrode profile (Rn') corresponds to the size of the capacity range of the measured full-cell profile M.

In addition, the capacity range by the two points (pi', pf") of the adjusted reference positive electrode profile (Rp") matches the capacity range by the two points (ni, nf') of the adjusted reference negative electrode profile (Rn'). The processor 320 may generate a comparison full-cell profile S by subtracting the profile between two points (pi', pf") of the adjusted reference positive electrode profile (Rp") from the profile between two points (ni, nf') of the adjusted reference negative electrode profile (Rn').

The processor 320 may calculate an error (profile error) between the comparison value between the comparison full-cell profile S and the measurement full-cell profile M.

The processor 320 may map at least two of the adjusted reference positive electrode profile (Rp"), the adjusted reference negative electrode profile (Rn'), the positive electrode participation start point (pi'), the positive electrode participation end point (pf"), the negative electrode participation start point (ni), the negative electrode participation end point (nf'), the positive electrode scale factor, the negative electrode scale factor, the comparison full-cell profile S, and the profile error with each other and record the same in the memory unit 330.

The positive electrode scale factor may represent the ratio of the capacity difference between both ends of the adjusted reference positive electrode profile (Rp") to the capacity difference between both ends of the reference positive electrode profile Rp. Alternatively, the positive electrode scale factor may represent the ratio of the capacity difference between two points (pi', pf") to the capacity difference between two points (pi0, pf0). Alternatively, the positive electrode scale factor may represent the ratio of the positive electrode capacity difference between two points (pi', pf") to the positive electrode capacity difference between two points (pi0, pf0). Alternatively, the positive electrode scale factor may represent the ratio of the positive electrode SOC difference between two points (pi', pf") to the positive electrode SOC difference between two points (pi0, pf0).

The negative electrode scale factor may represent the ratio of the capacity difference between both ends of the adjusted reference negative electrode profile (Rn') to the capacity difference between both ends of the reference negative electrode profile Rn. Alternatively, the negative electrode scale factor may represent the ratio of the capacity difference between two points (ni, nf') to the capacity difference between two points (ni0, nf0). Alternatively, the negative electrode scale factor may represent the ratio of the negative electrode capacity difference between two points (ni, nf') to the negative electrode capacity difference between two points (ni0, nf0). Alternatively, the negative electrode scale factor may represent the ratio of the negative electrode SOC difference between two points (ni, nf') to the negative electrode SOC difference between two points (ni0, nf0).

Meanwhile, as described above, when the positive electrode voltage range of the reference positive electrode profile Rp is divided into a plurality of small voltage sections, the boundary point of two adjacent small voltage sections among the plurality of small voltage sections may be set as a positive electrode participation start point (pi).

For example, if the positive electrode voltage range of the reference positive electrode profile Rp is divided into 100 small voltage ranges, there may be 100 boundary points that can be set as the positive electrode participation start point (pi). Also, if the voltage range greater than or equal to the second set voltage in the reference positive electrode profile Rp is divided into 40 small voltage ranges, there may be 40 boundary points that can be set as the positive electrode participation end point (pf). In this case, at least 4,000 different comparison full-cell profiles may be generated.

Of course, it will be easily understood by those skilled in the art that as the size of the small voltage section decreases, the maximum number of comparison full-cell profiles that can be generated increases, and conversely, as the size of the small voltage section increases, the maximum number of comparison full-cell profiles that can be generated decreases.

The processor 320 may identify a minimum value among profile errors of the plurality of comparison full-cell profiles generated as described above, and then obtain information mapped to the minimum profile error (e.g., at least one of a positive electrode participation start point, a positive electrode participation end point, a negative electrode participation start point, a negative electrode participation end point, a positive electrode scale factor, and a negative electrode scale factor) from the memory unit 330.

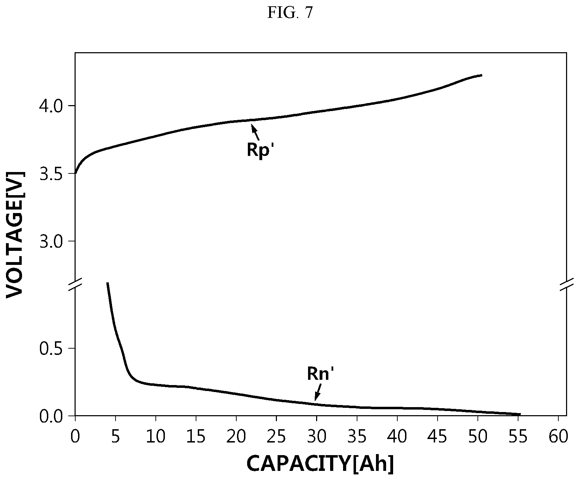

FIGS. 7 to 9 are diagrams referenced to describe another example of a procedure of generating a comparison full-cell profile used for comparison with the measurement full-cell profile according to an embodiment of the present disclosure. For reference, the embodiment shown in FIGS. 7 to 9 is independent from the embodiment shown in FIGS. 4 to 6. Accordingly, terms or reference signs commonly used to describe the embodiment shown in FIGS. 4 to 6 and the embodiment shown in FIGS. 7 to 9 should be understood as being limited to each embodiment.

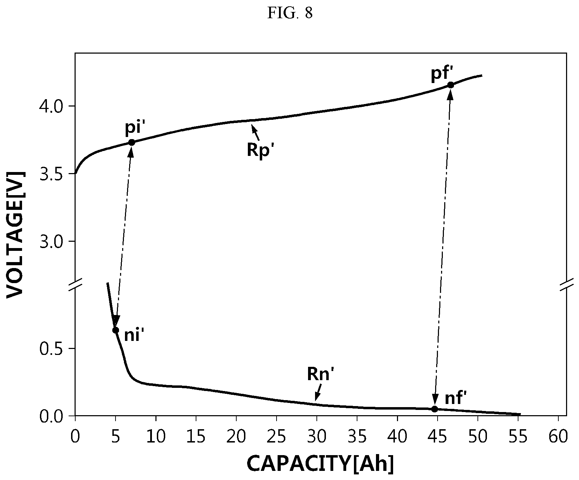

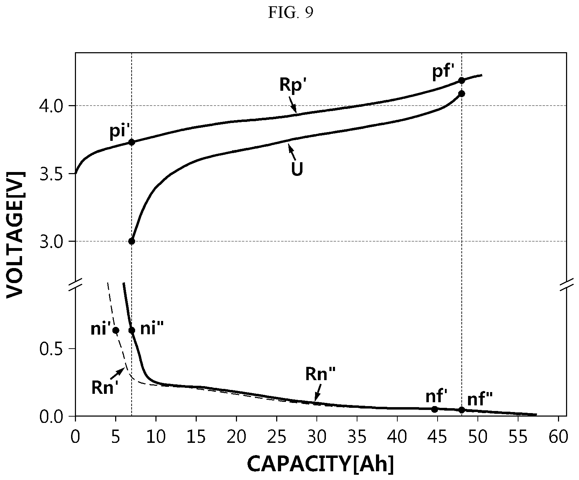

The procedure of generating a comparison full-cell profile to be explained with reference to FIGS. 7 to 9 proceeds in the order of a fourth routine (see FIG. 7) that performs the capacity scaling, a fifth routine (see FIG. 8) that sets four points (positive electrode participation start point, positive electrode participation end point, negative electrode participation start point, and negative electrode participation end point), and a sixth routine (see FIG. 9) that performs the profile shift. That is, the procedure of generating a comparison full-cell profile according to another embodiment of the present disclosure includes the fourth to sixth routines.

Referring to FIG. 7, the processor 320 generates an adjusted reference positive electrode profile (Rp') and an adjusted reference negative electrode profile (Rn') by applying the positive electrode scale factor and the negative electrode scale factor selected from the scaling value range to the reference positive electrode profile Rp and the reference negative electrode profile (Rn), respectively.

The scaling value range may be predetermined or may vary depending on the ratio of the size of the capacity range of the measurement full-cell profile M to the size of the capacity range of the reference full-cell profile (R). As an example, assuming that the positive electrode scale factor and the negative electrode scale factor can be selected among the values (i.e., 90%, 90.1%, 90.2%, ... 98.9%, 99%) spaced by 0.1% in the scaling value range (e.g., 90 to 99%), 91 values may be selected as the positive electrode scale factor and the negative electrode scale factor, respectively. In this case, according to $91 \times 91 = 8,281$ adjustment levels (combinations of the positive electrode scale factors and the negative electrode scale factors), a maximum of 8,281 adjusted profile pairs may be generated. The adjusted profile pair refers to a combination of an adjusted positive electrode profile and an adjusted negative electrode profile.

Referring to FIG. 7, the adjusted reference positive electrode profile (Rp') and the adjusted reference negative electrode profile (Rn') illustrate the result of applying the positive electrode scale factor and the negative electrode scale factor, respectively, to the reference positive electrode profile Rp and the reference negative electrode profile Rn.

Since the positive electrode scale factor and the negative electrode scale factor are less than 100%, the adjusted reference positive electrode profile (Rp') is obtained by shrinking the reference positive electrode profile Rp along the horizontal axis, and the adjusted reference negative electrode profile (Rn') is also obtained by shrinking the reference negative electrode profile Rn along the horizontal axis. To facilitate understanding, the reference positive electrode profile Rp and the reference negative electrode profile Rn are shown in a form in which the start points of them are respectively fixed and the remaining parts are shrunken to the left along the horizontal axis.

Referring to FIG. 8, the processor 320 determines a positive electrode participation start point (pi'), a positive electrode participation end point (pf'), a negative electrode participation start point (ni'), and a negative electrode participation end point (nf') on the adjusted reference positive electrode profile (Rp') and the adjusted reference negative electrode profile (Rp').

Either the positive electrode participation start point (pi') or the negative electrode participation start point (ni') may depend on the other. Also, either the positive electrode participation end point (pf') or the negative electrode participation end point (nf') may depend on the other. Also, either the positive electrode participation start point (pi') or the positive electrode participation end point (pf') may be set based on the other.

That is, if any one of the positive electrode participation start point (pi'), the positive electrode participation end point (pf'), the negative electrode participation start point (ni'), and the negative electrode participation end point (nf') is set, the remaining three points may be automatically set by the first set voltage, the second set voltage, and/or the size of the capacity range of the measurement full-cell profile M (e.g., 45Ah - 5Ah = 40Ah in FIG. 3b).

As an example, the processor 320 may divide the positive electrode voltage range from the start point to the end point (or, second set voltage) of the adjusted reference positive electrode profile (Rp') into a plurality of small voltage sections, and then determine a boundary point of two adjacent small voltage sections among the plurality of small voltage sections as the positive electrode participation start point (pi'). Next, the processor 320 may determine a point on the adjusted reference negative electrode profile (Rn') that is smaller than the positive electrode participation start point (pi') by the first set voltage (e.g., 3V) as the negative electrode participation start point (ni').

As another example, the processor 320 may divide the negative electrode voltage range from the start point to the end point of the adjusted reference negative electrode profile (Rn') into a plurality of small voltage sections of a predetermined size, and then determine a boundary point of two adjacent small voltage sections among the plurality of small voltage sections as the negative electrode participation start point (ni'). Next, the processor 320 may search for a point greater than the negative electrode participation start point (ni') by the first set voltage from the reference positive electrode profile Rp, and determine the searched point as the positive electrode participation start point (pi').

As still another example, the processor 320 may divide the voltage range from the second set voltage to the end point of the adjusted reference positive electrode profile (Rp') into a plurality of small voltage sections of a predetermined size, and then determine a boundary point of two adjacent small voltage sections among the plurality of small voltage sections as the positive electrode participation end point (pf'). Next, the processor 320 may search for a point smaller than the positive electrode participation end point (pf') by the second set voltage (e.g., 4V) from the adjusted reference negative electrode profile (Rn'), and determine the searched point as the negative electrode participation end point (nf').

As still another example, the processor 320 may divide the negative electrode voltage range from the start point to the end point of the adjusted reference negative electrode profile (Rn') into a plurality of small voltage section of a predetermined size, and then determine a boundary point of two adjacent small voltage sections among the plurality of small voltage sections as the negative electrode participation end point (nf'). Next, the processor 320 may search for a point greater than the negative electrode participation end point (nf') by the second set voltage from the adjusted reference positive electrode profile (Rp'), and determine the searched point as the positive electrode participation end point (pf').

If any one of the positive electrode participation start point (pi'), the positive electrode participation end point (pf'), the negative electrode participation start point (ni'), and the negative electrode participation end point (nf') is determined, the processor 320 may additionally determine at least one of the remaining three points based on the determined point.

For example, if the positive electrode participation start point (pi') is determined first, the processor 320 may determine a point on the adjusted reference positive electrode profile (Rp') having a capacity value that is larger than the capacity value of the positive electrode participation start point (pi') by the size of the capacity range of the measurement full-cell profile M as the positive electrode participation end point (pf'). In addition, the processor 320 may search for a point lower than the positive electrode participation start point (pi') by the first set voltage from the adjusted reference negative electrode profile (Rn'), and determine the searched point as the negative electrode participation start point (ni'). In addition, the processor 320 may determine a point on the adjusted reference negative electrode profile (Rn') having a capacity value greater than the capacity value of the negative electrode participation start point (ni') by the size of the capacity range of the measurement full-cell profile M as the negative electrode participation end point (nf').

As another example, when the positive electrode participation end point (pf') is determined first, the processor 320 may determine a point on the adjusted reference positive electrode profile (Rp') having a capacity value smaller than the capacity value of the positive electrode participation end point (pf') by the size of the capacity range of the measurement full-cell profile M as the positive electrode participation start point (pi'). In addition, the processor 320 may search for a point lower than the positive electrode participation end point (pf') by the second set voltage from the adjusted reference negative electrode profile (Rn'), and determine the searched point as the negative electrode participation end point (nf'). In addition, the processor 320 may determine a point on the adjusted reference negative electrode profile (Rn') having a capacity value smaller than the capacity value of the negative electrode participation end point (nf') by the size of the capacity range of the measurement full-cell profile M as the negative electrode participation start point (ni').

As still another example, when the negative electrode participation start point (ni') is determined, the processor 320 may determine a point on the adjusted reference negative electrode profile (Rn') having a capacity value larger than the capacity value of the negative electrode participation start point (ni') by the size of the capacity range of the measurement full-cell profile M as the negative electrode participation end point (nf'). In addition, the processor 320 may search for a point higher than the negative electrode participation start point (ni') by the first set voltage from the adjusted reference positive electrode profile (Rp'), and determine the searched point as the positive electrode participation start point (pi'). In addition, the processor 320 may determine a point on the adjusted reference positive electrode profile (Rp') having a capacity value greater than the capacity value of the positive electrode participation start point (pi') by the size of the capacity range of the measurement full-cell profile M as the positive electrode participation end point (pf').

As still another example, when the negative electrode participation end point (nf') is determined, the processor 320 may determine a point on the adjusted reference negative electrode profile (Rn') having a capacity value smaller than the capacity value of the negative electrode participation end point (nf') by the size of the capacity range of the measurement full-cell profile M as the negative electrode participation start point (ni'). In addition, the processor 320 may search for a point higher than the negative electrode participation end point (nf') by the second set voltage from the adjusted reference positive electrode profile (Rp'), and determine the searched point as the positive electrode participation end point (pf'). In addition, the processor 320 may determine a point on the adjusted reference positive electrode profile (Rp') having a capacity value smaller than the capacity value of the positive electrode participation end point (pf') by the size of the capacity range of the measurement full-cell profile M as the positive electrode participation start point (pi').

If the positive electrode participation start point (pi'), the positive electrode participation end point (pf'), the negative electrode participation start point (ni') and the negative electrode participation end point (nf') are completely determined based on the pair of positive electrode scale factor and negative electrode scale factor, the processor 320 may shift at least one of the adjusted reference positive electrode profile (Rp') and the adjusted reference negative electrode profile (Rn') to the left or right along the horizontal axis so that the capacity values of the positive electrode participation start point (pi') and the negative electrode participation start point (ni') match or the capacity values of the positive electrode participation start point (pf') and the negative electrode participation start point (nf') match.

The adjusted reference negative electrode profile (Rn") shown in FIG. 9 is obtained by shifting only the adjusted reference negative electrode profile (Rn') shown in FIG. 8 to the right. Accordingly, the capacity values of the positive electrode participation start point (pi') and the negative electrode participation start point (ni") match each other on the horizontal axis. Relatedly, the capacity difference between the positive electrode participation start point (pi') and the positive electrode participation end point (pf') is equal to the capacity difference between the negative electrode participation start point (ni') and the negative electrode participation end point (nf'). Therefore, if the capacity values of the positive electrode participation start point (pi') and the negative electrode participation start point (ni") match each other, the capacity values of the positive electrode participation end point (pf') and the negative electrode participation end point (nf") also match each other on the horizontal axis.

Referring to FIG. 9, the processor 320 may generate a comparison full-cell profile U by subtracting the partial profile between two points (pi', pf') of the adjusted reference positive electrode profile (Rp') from the partial profile between two points (ni", nf") of the adjusted reference negative electrode profile (Rn").

The processor 320 may calculate an error (profile error) between the comparison full-cell profile U and the measurement full-cell profile M.

The processor 320 may map at least two of the adjusted reference positive electrode profile (Rp'), the adjusted reference negative electrode profile (Rn"), the positive electrode participation start point (pi'), the positive electrode participation end point (pf'), the negative electrode participation start point (ni"), the negative electrode participation end point (nf"), the positive electrode scale factor, the negative electrode scale factor, the comparison full-cell profile U and the profile error with each other and record the same in the memory unit 330.

As described above, the processor 320 may generate a comparison full-cell profile corresponding to each pair of the positive electrode scale factor and the negative electrode scale factor selected from the scaling value range. Since the pairs of positive electrode scale factor and negative electrode scale factor are plural, it is obvious that the comparison profile will also be generated in plural numbers. The processor 320 may identify a minimum value among profile errors of the plurality of comparison full-cell profiles, and then obtain information mapped to the minimum profile error from the memory unit 330.

The processor 320 may determine the negative electrode loading amount of the target cell BC from the information mapped to the minimum profile error. The processor 320 may estimate the negative electrode loading amount of the target cell BC based on the extracted negative electrode scale factor. For reference, at least one of the positive electrode participation start point, the positive electrode participation end point, the negative electrode participation start point, the negative electrode participation end point, the positive electrode scale factor, and the negative electrode scale factor when the target cell BC is in the new state may be already recorded in the memory unit 330 by executing the aforementioned analysis process when the target cell BC is in the new state.

The processor 320 may determine at least one degradation parameter (e.g., negative electrode loading amount) based on the information mapped to the minimum profile error. Table 1 below summarizes degradation parameters and formulas that may be used to determine each degradation parameter.

Table 1

| Degradation parameter | Formula |
|---|---|
| $P_{SOH}$ | $1 - \dfrac{pf_{BOL} - pf_{MOL}}{pf_{BOL} - pi_{BOL}},\ \dfrac{pf_{MOL} - pi_{BOL}}{pf_{BOL} - pi_{BOL}},\ 1 - \dfrac{pf_{BOL} - pf_{MOL}}{nf_{BOL} - ni_{BOL}},\ \dfrac{ps_{MOL}}{ps_{BOL}}$ |
| $N_{SOH}$ | $\dfrac{ns_{MOL}}{ns_{BOL}}$ |
| $L_{SOH}$ | $1 - \dfrac{pi_{MOL} - pi_{BOL}}{pf_{BOL} - pi_{BOL}},\ \dfrac{pf_{BOL} - pi_{MOL}}{pf_{BOL} - pi_{BOL}},\ 1 - \dfrac{pi_{MOL} - pi_{BOL}}{nf_{BOL} - ni_{BOL}}$ |
| $F_{SOH}$ | $\dfrac{pf_{MOL} - pi_{MOL}}{pf_{BOL} - pi_{BOL}},\ \dfrac{nf_{MOL} - ni_{MOL}}{nf_{BOL} - ni_{BOL}}$ |
| $P_{LOSS}$ | $\dfrac{pf_{BOL} - pf_{MOL}}{pf_{BOL} - pi_{BOL}},\ \dfrac{pf_{BOL} - pf_{MOL}}{nf_{BOL} - ni_{BOL}},\ 1 - \dfrac{ps_{MOL}}{ps_{BOL}}$ |
| $N_{LOSS}$ | $1 - \dfrac{ns_{MOL}}{ns_{BOL}}$ |
| $L_{LOSS}$ | $\dfrac{pi_{MOL} - pi_{BOL}}{pf_{BOL} - pi_{BOL}},\ \dfrac{pi_{MOL} - pi_{BOL}}{nf_{BOL} - ni_{BOL}}$ |
| $F_{LOSS}$ | $1 - \dfrac{pf_{MOL} - pi_{MOL}}{pf_{BOL} - pi_{BOL}},\ 1 - \dfrac{nf_{MOL} - ni_{MOL}}{nf_{BOL} - ni_{BOL}},\ \dfrac{(pf_{BOL} - pi_{BOL}) - (pf_{MOL} - pi_{MOL})}{nf_{BOL} - ni_{BOL}}$ |
| $P_{loading\_MOL}$ | $ps_{MOL} \times P_{loading\_ref}$ |
| $N_{loading\_MOL}$ | $ns_{MOL} \times N_{loading\_ref}$ |

Each of the variables listed in Table 1 is a diagnostic factor that may be determined by the analyzing process described above. The definitions of the degradation parameters and variables in Table 1 may be as follows.

<Degradation parameters >

$P_{SOH}$: positive electrode SOH (State Of Health) of the target cell BC
$N_{SOH}$: negative electrode SOH of the target cell BC
$L_{SOH}$: available lithium SOH of the target cell BC

$F_{SOH}$: full-cell SOH of the target cell BC
$P_{LOSS}$: positive electrode loss rate of the target cell BC
$N_{LOSS}$: negative electrode loss rate of the target cell BC
$L_{LOSS}$: available lithium loss rate of the target cell BC
$F_{LOSS}$: full-cell loss rate of the target cell BC
$P_{loading\_MOL}$: positive electrode loading amount of the target cell BC
$N_{loading\_MOL}$: negative electrode loading amount of the target cell BC

The positive electrode loading amount of any battery cell represents the amount of positive electrode active material (or available capacity) per unit area of the positive electrode of the battery cell. The negative electrode loading amount of any battery cell represents the amount of negative electrode active material (or available capacity) per unit area of the negative electrode of the battery cell. The unit of the loading amount may be mAh/cm$^2$ or mg/cm$^2$. In Table 1, $P_{loading\_ref}$ represents the reference positive electrode loading amount, and $N_{loading\_ref}$ represents the reference negative electrode loading amount. The reference positive electrode loading amount is a predetermined value representing the amount of positive electrode active material (or available capacity) per unit area of the positive electrode of the reference cell. The reference positive electrode loading amount may be a value obtained by dividing the reference positive electrode capacity by the reference positive electrode area. Here, the reference positive electrode capacity may be a value preset as the total positive electrode capacity of the reference cell. The reference positive electrode area may be a value preset as the area of the positive electrode of the reference cell. The reference negative electrode loading amount is a predetermined value representing the amount of negative electrode active material (or available capacity) per unit area of the negative electrode of the reference cell. The reference negative electrode loading amount may be a value obtained by dividing the reference negative electrode capacity by the reference negative electrode area. Here, the reference negative electrode capacity may be a value preset as the total negative electrode capacity of the reference cell. The reference negative electrode area may be a value preset as the area of the negative electrode of the reference cell.

<Variables>

$pi_{BOL}$: positive electrode capacity (positive electrode SOC) of the positive electrode participation start point when the target cell BC is in the BOL state
$pi_{MOL}$: positive electrode capacity (positive electrode SOC) of the current positive electrode participation start point (e.g., pi' shown in FIG. 6) of the target cell BC
$pf_{BOL}$: positive electrode capacity (positive electrode SOC) of the positive electrode participation end point when the target cell BC is in the BOL state
$pf_{MOL}$: positive electrode capacity (positive electrode SOC) of the current positive electrode participation end point (e.g., pf" shown in FIG. 6) of the target cell BC
$ni_{BOL}$: negative electrode capacity (negative electrode SOC) at the negative electrode participation start point when the target cell BC is in the BOL state
$ni_{MOL}$: negative electrode capacity (negative electrode SOC) of the current negative electrode participation start point (e.g., ni shown in FIG. 6) of the target cell BC
$nf_{BOL}$: negative electrode capacity (negative electrode SOC) of the negative electrode participation end point when the target cell BC is in the BOL state
$nf_{MOL}$: negative electrode capacity (negative electrode SOC) of the current negative electrode participation end point (e.g., nf' shown in FIG. 6) of the target cell BC
$ps_{BOL}$: positive electrode scale factor when the target cell BC is in the BOL state
$ps_{MOL}$: current positive electrode scale factor of the target cell BC
$ns_{BOL}$: negative electrode scale factor when the target cell BC is in the BOL state
$ns_{MOL}$: current negative electrode scale factor of the target cell BC

The process of determining a diagnostic factor for the target cell BC may be repeated periodically or aperiodically throughout the life of the target cell BC.
As the available lithium capacity, the total positive electrode capacity, and/or the total negative electrode capacity of the battery cell decreases, the positive electrode capacity (positive electrode SOC) of the positive electrode participation start point of the corresponding battery cell may have a characteristic of gradually increasing. The available lithium amount of a battery cell may be a parameter representing the total amount of lithium that may contribute to charging and discharging of the battery cell. The available lithium amount may gradually decrease from a new product state due to side reactions occurring inside the battery cell during charging and discharging of the battery cell.

Based on this characteristic, the processor 320 may determine whether the loss of available lithium of the target cell BC occurs due to the loss of at least one of the available lithium amount and the total positive electrode capacity, based on the estimation result of the positive electrode participation start point of the target cell BC.

The processor 320 may diagnose that available lithium loss has occurred in response to the positive electrode capacity (or positive electrode SOC) of the positive electrode participation start point increasing from the value in the new product state.

There may be a situation where the change amount of each of the positive electrode capacity (or positive electrode SOC) of the positive electrode participation start point of the target cell BC and the negative electrode capacity (or negative electrode SOC) of the negative electrode participation end point from the new product state is less than a predetermined set value. If so, the processor 320 may determine that the loss of capacity in at least one of the positive electrode and the negative electrode has contributed more to the change of the negative electrode participation start point of the target cell BC from the new product state than the loss of the available lithium amount, as the increase amount of the negative electrode capacity (or negative electrode SOC) of the negative electrode participation start point from the new product state is larger.

The processor 320 may limit at least one of the allowable voltage range and the allowable SOC range for the target cell BC based on the positive electrode participation start point estimated for the target cell BC. Relationship data representing a predetermined positive correlation between a change amount (e.g., an increase amount) of the positive electrode capacity (or positive electrode SOC) of the positive electrode participation start point from a new product state and a limit level may be stored in advance in the memory unit 330. That is, according to the relationship data, a decrease or increase in the capacity value (positive electrode capacity, or positive electrode SOC) of the positive electrode participation start point may cause reduction of at least one of the allowable voltage range and the allowable SOC range. Reducing a range means at least one of increasing a lower limit of the range and decreasing an upper limit of the range. For example, it is assumed that the allowable voltage range and the allowable SOC range are 2.5 V to 4.5 V and 5% to 95%, respectively. If the positive electrode capacity of the positive electrode participation start point is estimated to be 110% of the value in the BOL state, the allowable voltage range may be reduced to 2.75 V to 4.05 V, and the allowable SOC range may be reduced to 5.5% to 85.5%.

The processor 320 may diagnose that capacity loss occurs at the positive electrode of the target cell BC in response to a decrease in the positive electrode capacity (or positive electrode SOC) of the positive electrode participation end point from the value in the new product state.

The processor 320 may limit at least one of the allowable voltage range and the allowable SOC range for the target cell BC based on the positive electrode participation end point. Relationship data representing a predetermined positive correlation between a change amount (e.g., decrease amount) of the positive electrode capacity (or positive electrode SOC) of the positive electrode participation end point from a new product state and a limit level may be stored in advance in the memory unit 330. That is, according to the relationship data, a decrease in the capacity value (positive electrode capacity, positive electrode SOC) of the positive electrode participation end point may cause a reduction in at least one of the allowable voltage range and the allowable SOC range. For example, it is assumed that the allowable voltage range and the allowable SOC range are 2.5 V to 4.5 V and 5% to 95%, respectively. If the positive electrode participation end point is estimated to be 90% of the value in the BOL state, the allowable voltage range may be reduced to 2.75 V to 4.05 V, and the allowable SOC range may be reduced to 5.5% to 85.5%.

The processor 320 may limit at least one of the allowable voltage range and the allowable SOC range for the target cell BC based on the estimated positive electrode scale factor of the target cell BC. Relationship data representing a predetermined positive correlation between a change amount (e.g., decrease amount) of the positive electrode scale factor from a BOL state and a limit level may be stored in advance in the memory unit 330. That is, according to the relationship data, a decrease in the positive electrode scale factor may cause a reduction in at least one of the allowable voltage range and the allowable SOC range. For example, it is assumed that the allowable voltage range and the allowable SOC range are 2.5 V to 4.5 V and 5% to 95%, respectively. If the current positive electrode scale factor $ps_{MOL}$ of the target cell BC is estimated to be 90% of the positive electrode scale factor $ps_{BOL}$ in a new product state, the allowable voltage range may be reduced to 2.75 V to 4.05 V, and the allowable SOC range may be reduced to 5.5% to 85.5%.

The processor 320 may limit at least one of the allowable voltage range and the allowable SOC range for the target cell BC based on an estimate value of the positive electrode loading amount of the target cell BC. Relationship data representing a predetermined positive correlation between the positive electrode loading amount and the limit level may be stored in advance in the memory unit 330. That is, according to the relationship data, a decrease in the positive electrode loading amount may cause a reduction in at least one of the allowable voltage range and the allowable SOC range. For example, it is assumed that the allowable voltage range and the allowable SOC range are 2.5 V to 4.5 V and 5% to 95%, respectively. If the positive electrode loading amount is estimated to be 90% of the reference positive electrode loading amount, the allowable voltage range may be reduced to 2.75 V to 4.05 V, and the allowable SOC range may be reduced to 5.5% to 85.5%.

The processor 320 may limit at least one of the allowable voltage range and the allowable SOC range for the target cell BC based on the negative electrode participation start point of the target cell BC. Relationship data representing a predetermined positive correlation between a change amount (e.g., decrease amount) of the negative electrode capacity (or negative electrode SOC) of the negative electrode participation start point from a new product state and a limit level may be stored in advance in the memory unit 330. That is, according to the relationship data, a decrease or increase in the capacity value (negative electrode capacity, or negative electrode SOC) of the negative electrode participation start point may cause a reduction in at least one of the allowable voltage range and the allowable SOC range. For example, it is assumed that the allowable voltage range and the allowable SOC range are 2.5 V to 4.5 V and 5% to 95%, respectively. If the negative electrode capacity of the current negative electrode participation start point is estimated to be 90% of the value in the BOL state, the allowable voltage range may be reduced to 2.75 V to 4.05 V, and the allowable SOC range may be reduced to 5.5% to 85.5%.

The processor 320 may diagnose that a capacity loss occurs at the negative electrode of the target cell BC in response to a decrease in the negative electrode capacity (or negative electrode SOC) of the negative electrode participation end point from a value in a new product state. The processor 320 may limit at least one of the allowable voltage range and the allowable SOC range for the target cell BC based on the estimated negative electrode participation end point for the target cell BC. Relationship data representing a predetermined positive correlation between a change amount (e.g., decrease amount) of the negative electrode capacity (or negative electrode SOC) of the negative electrode participation end point from a new product state and a limit level may be stored in advance in the memory unit 330. That is, according to the relationship data, a decrease in the capacity value (negative electrode capacity, negative electrode SOC) of the negative electrode participation end point may cause a reduction in at least one of the allowable voltage range and the allowable SOC range. For example, it is assumed that the allowable voltage range and the allowable SOC range are 2.5 V to 4.5 V and 5% to 95%, respectively. If the current negative electrode participation end point is estimated to be 90% of the value in the BOL state, the allowable voltage range may be reduced to 2.75 V to 4.05 V, and the allowable SOC range may be reduced to 5.5% to 85.5%.

The processor 320 may limit at least one of the allowable voltage range and the allowable SOC range for the target cell BC based on the estimated negative electrode scale factor of the target cell BC. Relationship data representing a predetermined positive correlation between a decrease amount of the negative electrode scale factor from a BOL state and a limit level may be stored in advance in the memory unit 330. That is, according to the relationship data, a decrease in the negative electrode scale factor may cause a reduction in at least one of the allowable voltage range and the allowable SOC range. For example, it is assumed that the allowable voltage range and the allowable SOC range are 2.5 V to 4.5 V and 5% to 95%, respectively. If the current negative electrode scale factor, $ns_{MOL}$, of the target cell BC is estimated to be 90% of the negative electrode scale factor, $ns_{BOL}$, in a new product state, the allowable voltage range may be reduced to 2.75 V to 4.05 V, and the allowable SOC range may be reduced to 5.5% to 85.5%. The processor 320 may limit at least one of an allowable voltage range and an allowable SOC range for the target cell BC based on an estimation value of the negative electrode loading amount of the target cell BC. Relationship data indicating a predetermined positive correlation between a decrease amount of the negative electrode loading amount from the BOL state and the limit level may be stored in advance in the memory unit 330. That is, according to the relationship data, a decrease in the negative electrode loading amount may cause a reduction of at least one of the allowable voltage range and the allowable SOC range. For example, it is assumed that the allowable voltage range and the allowable SOC range are 2.5V to 4.5V and 5% to 95%, respectively. If the current negative electrode loading amount $N_{loading\_MOL}$ is estimated to be 90% of the value $N_{loading\_BOL}$ in the BOL state, the allowable voltage range may be reduced to 2.75V to 4.05V, and the allowable SOC range may be reduced to 5.5% to 85.5%.

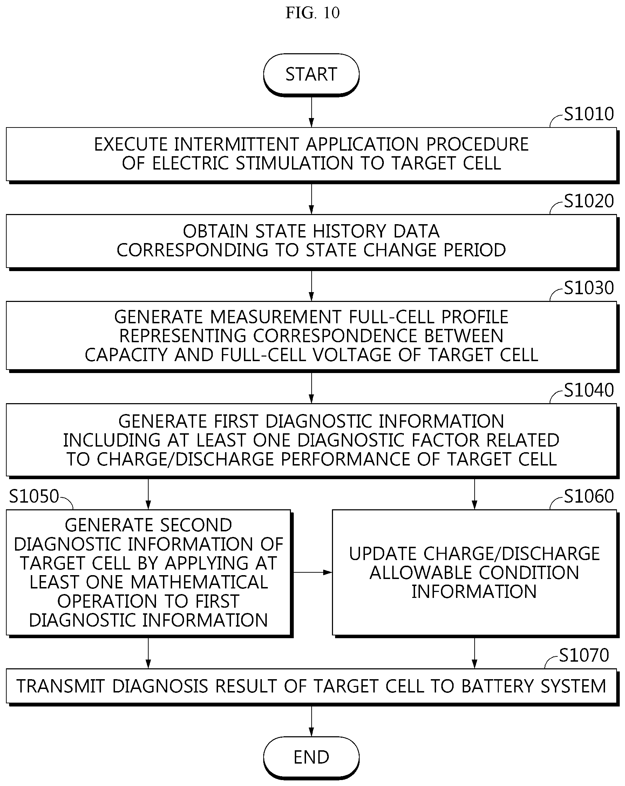

FIG. 10 is a flowchart referenced to exemplarily describe a battery diagnosis method according to the first embodiment of the present disclosure. The method according to FIG. 10 may be performed by the battery diagnosis apparatus 302.

In Step S1010, the processor 320 executes an intermittent application procedure of electric stimulation to the target cell BC. Specifically, the processor 320 may control the stimulation applying device 301 to intermittently apply electric stimulation (e.g., second electric stimulation) to the target cell BC during a state change period until the electric state of the target cell BC changes from a first state to a second state.

The intermittent application procedure of electric stimulation may be a procedure in which an application period of electric stimulation and a rest period are repeated. That is, the intermittent application procedure includes at least two application procedures and at least two rest procedures. When the current integration value of the target cell BC changes by a threshold integration value while electric stimulation is applied by each application procedure, the electric stimulation for the target cell BC may be removed (output may be stopped) to provide a rest period. When the duration of the rest period by each rest procedure reaches a reference time, the application procedure of electric stimulation may be resumed.

Step S1010 may be executed by the battery management system 100 or the system controller 2 instead of the processor 320, and in this case, Step S1010 may be omitted from the method of FIG. 10.

In step S1020, the processor 320 obtains state history data of the target cell BC corresponding to the state change period using the data obtaining unit 310. The state history data includes voltage history data and may further include current history data or capacity history data.

The voltage history data may include voltage values representing the full-cell voltage of the target cell BC measured at least once in each of the rest periods of the electric stimulation applied during the state change period. That is, the voltage history data may represent a change history of the full-cell voltage of the target cell BC over the state change period. The voltage history data may include the measurement value of the full-cell voltage of the target cell BC at the end of each rest period (see $D_{OCV}$ of FIG. 3a). The data obtaining unit 310 may collect state history data generated by the battery system 1 from the battery system 1 after the end of the state change period.

Alternatively, the data obtaining unit 310 may periodically collect measurement data representing at least one measurement value of the current and the full-cell voltage of the target cell BC from the battery system 1 during the state change period. In this case, each measurement value collected multiple times during the state change period may be recorded in time sequence in the memory unit 330. The processor 320 may generate state history data from the set of measurement values collected during the state change period.

In Step S1030, the processor 320 generates a measurement full-cell profile (see M in FIG. 3b) indicating a correspondence between the capacity and the full-cell voltage of the target cell BC based on the state history data.

In Step S1040, the processor 320 analyzes the measurement full-cell profile to generate first diagnostic information including at least one diagnostic factor related to the charge/discharge performance of the target cell BC.

The first diagnostic information may include at least one of a positive electrode participation start point, a positive electrode participation end point, a positive electrode scale factor, and a positive electrode loading amount, which represents the charge/discharge performance of the positive electrode of the target cell BC, as a diagnostic factor. The positive electrode loading amount represents the amount of positive electrode active material per unit area of the positive electrode.

The first diagnostic information may include at least one of a negative electrode participation start point, a negative electrode participation end point, a negative electrode scale factor, and a negative electrode loading amount, which represents the charge/discharge performance of the negative electrode of the target cell BC, as a diagnostic factor. The negative electrode loading amount represents the amount of negative electrode active material per unit area of the negative electrode.

In Step S1050, the processor 320 generates second diagnostic information of the target cell BC by applying at least one mathematical operation to the first diagnostic information. The second diagnostic information may include at least one degradation parameter regarding at least one of the positive electrode, the negative electrode, and the available lithium (see Table 1, etc.).

The second diagnostic information may include whether the available lithium loss of the target cell BC occurs and/or the available lithium loss rate, determined based on the positive electrode participation start point of the first diagnostic information.

The second diagnostic information may include whether the positive electrode capacity loss occurs and/or the positive electrode loss rate of the target cell BC, determined based on the positive electrode participation end point, the positive electrode scale factor, and/or the positive electrode loading amount of the first diagnostic information.

The second diagnostic information may include whether the loss of available lithium occurs in the target cell BC, whether the capacity loss occurs in the positive electrode, whether the capacity loss occurs in the negative electrode, and/or the negative electrode loss rate, which are determined based on the negative electrode participation start point, the negative electrode participation end point, and/or the negative electrode scale factor of the first diagnostic information.

The second diagnostic information may include the negative electrode loss rate (which may also be referred to as the 'negative electrode capacity loss rate') of the target cell BC, which is determined based on the negative electrode loading amount of the first diagnostic information.

In Step S1060, the processor 320 updates charge/discharge allowable condition information representing at least one of the voltage range, the SOC range, and the current range allowed for the target cell BC based on at least one of the first diagnostic information and the second diagnostic information.

For example, the processor 320 may determine updated charge/discharge allowable condition information by limiting (e.g., downwardly adjusting) at least one of the voltage range, the SOC range, and the current range for the target cell BC of the previous charge/discharge allowable condition information based on at least one degradation parameter (e.g., negative electrode loading amount) of the first diagnostic information.

In Step S1070, the processor 320 may transmit the diagnosis result of the target cell BC to the battery system 1 using the data obtaining unit 310. The diagnosis result includes at least one of the first diagnostic information, the second diagnostic information, and the updated charge/discharge allowable condition information.

In the method according to FIG. 10, at least one of Steps S1050, S1060, and S1070 may be omitted from the method according to FIG. 10.

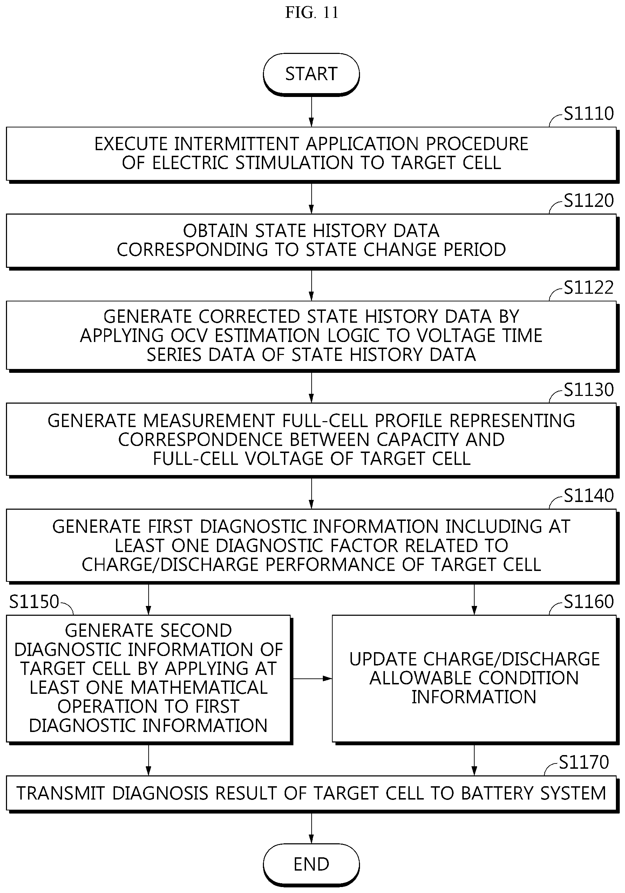

FIG. 11 is a flowchart referenced to exemplarily describe a battery diagnosis method according to the second embodiment of the present disclosure. The method according to FIG. 11 may be performed by the battery diagnosis apparatus 302.

In Step S1110, the processor 320 executes an intermittent application procedure of electric stimulation to the target cell BC.

In Step S1120, the processor 320 obtains state history data corresponding to the state change period using the data obtaining unit 310.

Unlike S1020 of FIG. 10 according to the first embodiment described above, the voltage history data of the state history data obtained in Step S1120 includes measurement values of the full-cell voltage measured three or more times per rest period during the state change period.

In Step S1122, the processor 320 applies the OCV estimation logic to the voltage history data of the state history data acquired in Step S1120 to generate the corrected state history data. The OCV estimation logic may be provided to replace a set of measurement values of three full-cell voltage per rest period included in the state history data obtained in Step S1120 with a single OCV value. Accordingly, if a total of X rest periods are granted during the state change period and the full-cell voltage is measured three times per rest period, it will be easily understood by those skilled in the art that the voltage history data obtained in Step S1120 will include 3X full-cell voltage measurement values, and the corrected voltage history data will include X OCV values.

In Step S1130, the processor 320 generates a measurement full-cell profile (see M in FIG. 3b) indicating a correspondence between the capacity and the full-cell voltage of the target cell BC based on the corrected state history data.

In Step S1140, the processor 320 analyzes the measurement full-cell profile to generate first diagnostic information including at least one diagnostic factor associated with the charge/discharge performance of the target cell BC.

In Step S1150, the processor 320 generates second diagnostic information of the target cell BC by applying at least one mathematical operation to the first diagnostic information.

In Step S1160, the processor 320 updates charge/discharge allowable condition information representing at least one of the voltage range, the SOC range, and the current range allowed for the target cell BC based on at least one of the first diagnostic information and the second diagnostic information.

In Step S1170, the processor 320 may transmit the diagnosis result of the target cell BC to the battery system 1 through the data obtaining unit 310.

In the method according to FIG. 11, Steps S1110, S1140, S1150, S1160 and S1170 may be substantially the same as Steps S1010, S1040, S1050, S1060 and S1070 of the method according to FIG. 10, respectively. In the method according to FIG. 11, at least one of Steps S1150, S1160 and S1170 may be omitted from the method according to FIG. 10.

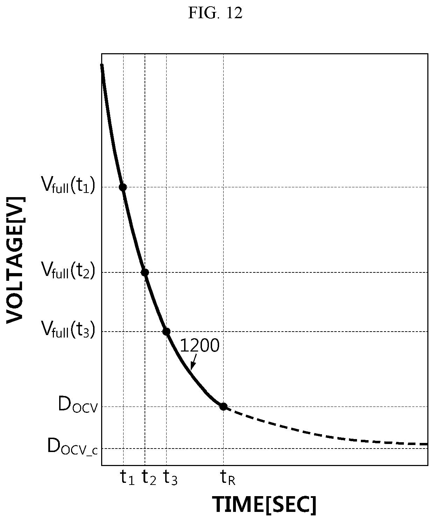

FIG. 12 is a drawing referenced to describe a procedure of correcting voltage history data performed in Step S1122 of FIG. 11.

The symbol 1200 in FIG. 12 indicates one of the voltage falling segments illustrated in FIG. 3a. $t_R$ indicates a time point at which a reference time has elapsed from the initiation time point of the rest period. The portion up to $t_R$ is depicted as a solid line, and the portion after $t_R$ is depicted as a dotted line.

Referring to FIG. 12, during each rest period, the target cell BC is placed in a no-load state with neither charging nor discharging.

During the no-load state, the full-cell voltage of the target cell BC gradually converges toward the OCV corresponding to the SOC of the target cell BC. The behavior of the full-cell voltage of the target cell BC in a specific rest period may be equivalent to the voltage response of a primary RC circuit, such as Formula 1 below.

<Formula 1>

$$V_{full}(t) = V_{OCV} + (V_S - V_{OCV}) \times e^{-\frac{t}{\tau}}$$

In Formula 1, t is an elapsed time from the start time point of a specific rest period, $V_{full}(t)$ is a full-cell voltage at t, $V_{OCV}$ is an actual OCV, $V_S$ is a full-cell voltage at the start time point of a specific rest period, and $\tau$ is a time constant determined by the internal resistance and capacitance of the target cell BC.

In Formula 1, $V_{full}(t)$ is measurable, so $V_{OCV}$, $V_S$, and $\tau$ are unknown. Since there are three unknown values, OCV of a specific rest period may be estimated based on $V_{full}(t)$ measured at three different timings in a specific rest period. Formula 2 below may be used to estimate OCV of each rest period.

<Formula 2>

$$\frac{V_{full}(t_1) - V_{OCV}}{V_{full}(t_2) - V_{OCV}} = \frac{V_{full}(t_2) - V_{OCV}}{V_{full}(t_3) - V_{OCV}}$$

In Formula 2, $t_1$, $t_2$ and $t_3$ are sequential measurement timings of the full-cell voltage. The time difference between $t_1$ and $t_2$ may be the same as the time difference between $t_2$ and $t_3$. Meanwhile, in FIG. 12, $t_R$ and $t_3$ are illustrated as being different, but it is also possible that $t_R = t_3$. In this case, $V_{full}(t_3) = D_{OCV}$.

The processor 320 may determine $D_{OCV\_C}$ in the same way as $V_{OCV}$ calculated through Formula 2.

The processor 320 may convert the voltage history data obtained in step S1120 into corrected voltage history data for step S1130 by repeating the process of replacing three full-cell voltage measurement values ($V_{full}(t_1)$, $V_{full}(t_2)$, $V_{full}(t_3)$) for each rest period with a single OCV value ($D_{OCV\_C}$) for all rest periods. The corrected voltage history data contains X OCV values. The processor 320 may apply the curve fitting logic to the corrected voltage history data to generate a measurement full-cell profile M.

For reference, $D_{OCV}$ is the measurement value of the full-cell voltage at the end time point of the rest period (before polarization is completely resolved), while $D_{OCV\_C}$ is the estimation value of the full-cell voltage (i.e., $V_{OCV}$) in a state where polarization is completely resolved. Therefore, it may be regarded that $D_{OCV\_C}$ is closer to the actual OCV of the target cell BC than $D_{OCV}$.

The embodiments of the present disclosure described hereinabove are not implemented only through the apparatus and method, and may be implemented through programs that perform functions corresponding to the configurations of the embodiments of the present disclosure or recording media having the programs recorded thereon, and such implementation may be easily achieved by those skilled in the art from the disclosure of the embodiments previously described.

While the present disclosure has been hereinabove described with regard to a limited number of embodiments and drawings, the present disclosure is not limited thereto and it is obvious to those skilled in the art that various modifications and changes may be made thereto within the technical aspects of the present disclosure and the equivalent scope of the appended claims.

Additionally, as many substitutions, modifications and changes may be made to the present disclosure described hereinabove by those skilled in the art without departing from the technical aspects of the present disclosure, the present disclosure is not limited by the above-described embodiments and the accompanying drawings, and some or all of the embodiments may be selectively combined to allow various modifications.

**Claims**

1. A battery diagnosis method comprising:

    obtaining state history data of a battery cell corresponding to a state change period until an electric state of the battery cell reaches a second state from a first state by an intermittent application procedure of electric stimulation to the battery cell;
    generating a measurement full-cell profile representing a correspondence between a capacity and a voltage of the battery cell based on the state history data; and
    generating first diagnostic information including at least one diagnostic factor related to charge/discharge performance of the battery cell by analyzing the measurement full-cell profile.

2. The battery diagnosis method according to claim 1,
    wherein the electric stimulation is a current stimulation that causes a transient voltage change exceeding a threshold value to the battery cell.

3. The battery diagnosis method according to claim 1,
    wherein the electric stimulation is a current stimulation that causes an overpotential exceeding a threshold value in the battery cell when the electric stimulation is continuously applied for a certain time.

4. The battery diagnosis method according to claim 1,
    wherein the electric stimulation is a charging current at a predetermined current rate.

**5.** The battery diagnosis method according to claim 1,
wherein the electric stimulation is a discharging current at a predetermined current rate.

**6.** The battery diagnosis method according to claim 1,
wherein the state history data includes voltage values representing the voltage of the battery cell measured at least once during each of rest periods of the electric stimulation applied within the state change period.

**7.** The battery diagnosis method according to claim 1,
wherein the intermittent application procedure includes a procedure for removing the electric stimulation to the battery cell so that a rest period is provided to the battery cell whenever a current integration value of the battery cell changes by a threshold integration value during the application of the electric stimulation.

**8.** The battery diagnosis method according to claim 7,
wherein the intermittent application procedure further includes a procedure for resuming application of the electric stimulation whenever a duration of the rest period reaches a reference time.

**9.** The battery diagnosis method according to claim 1,
wherein the first diagnostic information includes at least one of a positive electrode participation start point, a positive electrode participation end point, a positive electrode scale factor, and a positive electrode loading amount, which represents charge/discharge performance of a positive electrode of the battery cell, as the diagnostic factor.

**10.** The battery diagnosis method according to claim 9, further comprising:
generating second diagnostic information including at least one degradation parameter regarding the positive electrode or available lithium of the battery cell by applying a mathematical operation to the first diagnostic information.

**11.** The battery diagnosis method according to claim 1,
wherein the first diagnostic information includes at least one of a negative electrode participation start point, a negative electrode participation end point, a negative electrode scale factor, and a negative electrode loading amount, which represents charge/discharge performance of a negative electrode of the battery cell, as the diagnostic factor.

**12.** The battery diagnosis method according to claim 11, further comprising:
generating second diagnostic information including at least one degradation parameter regarding the negative electrode of the battery cell by applying a mathematical operation to the first diagnostic information.

**13.** The battery diagnosis method according to claim 10 or 12, further comprising:
updating charge/discharge allowable condition information representing at least one of a voltage range, a SOC range, and a current range allowed for the battery cell based on at least one of the first diagnostic information and the second diagnostic information.

**14.** A battery diagnosis apparatus comprising:

a data obtaining unit configured to obtain state history data of a battery cell corresponding to a state change period until an electric state of the battery cell reaches a second state from a first state by an intermittent application procedure of electric stimulation to the battery cell; and
a processor configured to generate a measurement full-cell profile representing a correspondence between a capacity and a voltage of the battery cell based on the state history data,
wherein the processor is configured to generate first diagnostic information including at least one diagnostic factor related to charge/discharge performance of the battery cell by analyzing the measurement full-cell profile.

**15.** The battery diagnosis apparatus according to claim 14,
wherein the intermittent application procedure includes a procedure for removing the electric stimulation to the battery cell so that a rest period is provided to the battery cell whenever a current integration value of the battery cell changes by a threshold integration value during the application of the electric stimulation.

**16.** The battery diagnosis apparatus according to claim 15,
wherein the intermittent application procedure further includes a procedure for resuming application of the electric stimulation whenever a duration of the rest period reaches a reference time.

17. The battery diagnosis apparatus according to claim 14,
wherein the first diagnostic information includes at least one of a positive electrode participation start point, a positive electrode participation end point, a positive electrode scale factor, and a positive electrode loading amount, which represents charge/discharge performance of a positive electrode of the battery cell, as the diagnostic factor.

18. The battery diagnosis apparatus according to claim 14,
wherein the first diagnostic information includes at least one of a negative electrode participation start point, a negative electrode participation end point, a negative electrode scale factor, and a negative electrode loading amount, which represents charge/discharge performance of a negative electrode of the battery cell, as the diagnostic factor.

19. A charging station comprising the battery diagnosis apparatus according to any one of claims 14 to 18.

20. A cloud server comprising the battery diagnosis apparatus according to any one of claims 14 to 18.

FIG. 1

FIG. 2

FIG. 3a

FIG. 3b

FIG. 4

FIG. 5

FIG. 6

FIG. 7

FIG. 8

FIG. 9

FIG. 10

START

|↓| S1010

EXECUTE INTERMITTENT APPLICATION PROCEDURE
OF ELECTRIC STIMULATION TO TARGET CELL

↓ S1020

OBTAIN STATE HISTORY DATA
CORRESPONDING TO STATE CHANGE PERIOD

↓ S1030

GENERATE MEASUREMENT FULL-CELL PROFILE
REPRESENTING CORRESPONDENCE BETWEEN
CAPACITY AND FULL-CELL VOLTAGE OF TARGET CELL

↓ S1040

GENERATE FIRST DIAGNOSTIC INFORMATION
INCLUDING AT LEAST ONE DIAGNOSTIC FACTOR RELATED
TO CHARGE/DISCHARGE PERFORMANCE OF TARGET CELL

S1050 ↓

GENERATE SECOND
DIAGNOSTIC INFORMATION OF
TARGET CELL BY APPLYING AT
LEAST ONE MATHEMATICAL
OPERATION TO FIRST
DIAGNOSTIC INFORMATION

→ S1060

UPDATE CHARGE/DISCHARGE
ALLOWABLE CONDITION
INFORMATION

↓ S1070

TRANSMIT DIAGNOSIS RESULT OF TARGET CELL TO BATTERY SYSTEM

↓

END

FIG. 11

```
                    ┌─────────┐
                    │  START  │
                    └─────────┘
                         │
                         ▼                              ⌐S1110
┌──────────────────────────────────────────────────────────┐
│       EXECUTE INTERMITTENT APPLICATION PROCEDURE           │
│          OF ELECTRIC STIMULATION TO TARGET CELL            │
└──────────────────────────────────────────────────────────┘
                         │
                         ▼                              ⌐S1120
┌──────────────────────────────────────────────────────────┐
│              OBTAIN STATE HISTORY DATA                      │
│        CORRESPONDING TO STATE CHANGE PERIOD                 │
└──────────────────────────────────────────────────────────┘
                         │
                         ▼                              ⌐S1122
┌──────────────────────────────────────────────────────────┐
│         GENERATE CORRECTED STATE HISTORY DATA BY           │
│    APPLYING OCV ESTIMATION LOGIC TO VOLTAGE TIME           │
│          SERIES DATA OF STATE HISTORY DATA                 │
└──────────────────────────────────────────────────────────┘
                         │
                         ▼                              ⌐S1130
┌──────────────────────────────────────────────────────────┐
│  GENERATE MEASUREMENT FULL-CELL PROFILE REPRESENTING       │
│       CORRESPONDENCE BETWEEN CAPACITY AND                  │
│          FULL-CELL VOLTAGE OF TARGET CELL                  │
└──────────────────────────────────────────────────────────┘
                         │
                         ▼                              ⌐S1140
┌──────────────────────────────────────────────────────────┐
│  GENERATE FIRST DIAGNOSTIC INFORMATION INCLUDING AT        │
│     LEAST ONE DIAGNOSTIC FACTOR RELATED TO                 │
│   CHARGE/DISCHARGE PERFORMANCE OF TARGET CELL              │
└──────────────────────────────────────────────────────────┘
```

S1150 ⌐

| GENERATE SECOND DIAGNOSTIC INFORMATION OF TARGET CELL BY APPLYING AT LEAST ONE MATHEMATICAL OPERATION TO FIRST DIAGNOSTIC INFORMATION | → | UPDATE CHARGE/DISCHARGE ALLOWABLE CONDITION INFORMATION |

S1160 ⌐

⌐S1170

TRANSMIT DIAGNOSIS RESULT OF TARGET CELL TO BATTERY SYSTEM

```
                    ┌─────────┐
                    │   END   │
                    └─────────┘
```

FIG. 12

## INTERNATIONAL SEARCH REPORT

| International application No. |
|---|
| **PCT/KR2024/014535** |

### A. CLASSIFICATION OF SUBJECT MATTER

**G01R 31/396**(2019.01)i; **G01R 31/367**(2019.01)i; **G01R 31/3842**(2019.01)i; **G01R 31/392**(2019.01)i; **G01R 31/36**(2006.01)i; **B60L 58/16**(2019.01)i; **H01M 10/052**(2010.01)i; **G01R 31/3828**(2019.01)i; **G01R 31/385**(2019.01)i; **H01M 10/48**(2006.01)i

According to International Patent Classification (IPC) or to both national classification and IPC

### B. FIELDS SEARCHED

Minimum documentation searched (classification system followed by classification symbols)

G01R 31/396(2019.01); B60L 58/12(2019.01); G01R 31/36(2006.01); G01R 31/367(2019.01); G01R 31/382(2019.01); G01R 31/392(2019.01); H01M 10/44(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 셀(battery cell), 전기 자극(electrical stimulation), 간헐적 인가(intermittent application), 상태 이력 데이터(status history data), 측정 풀셀 프로파일(measurement full cell profile), 제1 진단 정보(first diagnostic information)

### C. DOCUMENTS CONSIDERED TO BE RELEVANT

| Category* | Citation of document, with indication, where appropriate, of the relevant passages | Relevant to claim No. |
|---|---|---|
| X | JP 6034954 B2 (HITACHI, LTD.) 30 November 2016 (2016-11-30) See paragraphs [0012]-[0074] and claims 1 and 5. | 1,6-20 |
| Y | | 2-5 |
| Y | JP 7040601 B2 (MURATA MANUFACTURING CO., LTD.) 23 March 2022 (2022-03-23) See paragraph [0048]. | 2-5 |
| A | KR 10-2022-0093840 A (LG ENERGY SOLUTION, LTD.) 05 July 2022 (2022-07-05) See paragraphs [0046]-[0090], claims 1 and 4 and figure 3. | 1-20 |
| A | KR 10-2023-0072630 A (LG ENERGY SOLUTION, LTD.) 25 May 2023 (2023-05-25) See claim 1. | 1-20 |

☑ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **17 January 2025** | **17 January 2025** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2024/014535**

### C.     DOCUMENTS CONSIDERED TO BE RELEVANT

| Category* | Citation of document, with indication, where appropriate, of the relevant passages | Relevant to claim No. |
|---|---|---|
| A | KR 10-2023-0036929 A (LG ENERGY SOLUTION, LTD.) 15 March 2023 (2023-03-15)<br>See paragraphs [0012]-[0088]. | 1-20 |

Form PCT/ISA/210 (second sheet) (July 2022)

**INTERNATIONAL SEARCH REPORT**
Information on patent family members

International application No.

**PCT/KR2024/014535**

| Patent document cited in search report | | | Publication date (day/month/year) | Patent family member(s) | | | Publication date (day/month/year) |
|---|---|---|---|---|---|---|---|
| JP | 6034954 | B2 | 30 November 2016 | JP | WO2014-147753 | A1 | 16 February 2017 |
| | | | | WO | 2014-147753 | A1 | 25 September 2014 |
| JP | 7040601 | B2 | 23 March 2022 | CN | 111886752 | A | 03 November 2020 |
| | | | | CN | 111886752 | B | 06 August 2024 |
| | | | | EP | 3771020 | A1 | 27 January 2021 |
| | | | | EP | 3771020 | A4 | 15 December 2021 |
| | | | | US | 12071037 | B2 | 27 August 2024 |
| | | | | US | 2021-0001747 | A1 | 07 January 2021 |
| | | | | WO | 2019-181764 | A1 | 26 September 2019 |
| KR | 10-2022-0093840 | A | 05 July 2022 | CN | 115380221 | A | 22 November 2022 |
| | | | | EP | 4119962 | A1 | 18 January 2023 |
| | | | | EP | 4119962 | A4 | 29 November 2023 |
| | | | | JP | 2023-515838 | A | 14 April 2023 |
| | | | | JP | 7395809 | B2 | 12 December 2023 |
| | | | | US | 12066496 | B2 | 20 August 2024 |
| | | | | US | 2023-0236262 | A1 | 27 July 2023 |
| | | | | US | 2024-0377472 | A1 | 14 November 2024 |
| | | | | WO | 2022-145776 | A1 | 07 July 2022 |
| KR | 10-2023-0072630 | A | 25 May 2023 | | None | | |
| KR | 10-2023-0036929 | A | 15 March 2023 | CN | 116583754 | A | 11 August 2023 |
| | | | | EP | 4253972 | A1 | 04 October 2023 |
| | | | | EP | 4253972 | A4 | 31 July 2024 |
| | | | | JP | 2023-548898 | A | 21 November 2023 |
| | | | | JP | 7568209 | B2 | 16 October 2024 |
| | | | | US | 2024-0066993 | A1 | 29 February 2024 |
| | | | | WO | 2023-038398 | A1 | 16 March 2023 |

Form PCT/ISA/210 (patent family annex) (July 2022)

**EP 4 641 237 A1**

**Patent documents cited in the description**

- KR 1020230154875
- KR 1020240057162
- KR 1020230133644